(19) Europäisches Patentamt
European Patent Office
Office européen des brevets

(11) EP 4 232 518 B1

(12) **EUROPEAN PATENT SPECIFICATION**

(45) Date of publication and mention of the grant of the patent:
**18.02.2026 Bulletin 2026/08**

(21) Application number: **21815913.5**

(22) Date of filing: **18.10.2021**

(51) International Patent Classification (IPC):
***C09D 11/02*** *(2014.01)*

(52) Cooperative Patent Classification (CPC):
**C09D 11/101; C08F 2/48; C08F 2/50; C09D 11/037; C09D 11/38; C09K 11/02;** G02B 6/005; H10H 20/8513; H10H 20/8515

(86) International application number:
**PCT/EP2021/078730**

(87) International publication number:
**WO 2022/084209 (28.04.2022 Gazette 2022/17)**

(54) **COMPOSITION**

ZUSAMMENSETZUNG

COMPOSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.10.2020 EP 20202992**

(43) Date of publication of application:
**30.08.2023 Bulletin 2023/35**

(73) Proprietor: **Samsung Electronics Co., Ltd**
**Suwon-si, Gyeonggi-do 16677 (KR)**

(72) Inventors:
- **HIRAYAMA, Yuki**
  **TOKYO 153-8927 (JP)**
- **KISHIMOTO, Tadashi**
  **TOKYO 153-8927 (JP)**
- **GOTO, Tomohisa**
  **TOKYO 153-8927 (JP)**
- **SATO, Hiromoto**
  **TOKYO 153-8927 (JP)**
- **GREINERT, Nils**
  **64293 Darmstadt (DE)**
- **SUZUKI, Teruaki**
  **TOKYO 153-8927 (JP)**

(74) Representative: **Appleyard Lees IP LLP**
**15 Clare Road**
**Halifax HX1 2HY (GB)**

(56) References cited:
**WO-A1-2017/054898**
**WO-A1-2019/002239**
**WO-A1-2020/208127**
**WO-A1-2021/116139**
**US-A1- 2015 098 212**
**US-A1- 2018 102 449**
**US-A1- 2018 312 747**
**US-A1- 2019 218 453**
**US-A1- 2020 017 762**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 232 518 B1

## Description

### Field of the invention

The present invention relates to a photo-reactive composition comprising at least one light emitting moiety, a layer, a color conversion device, process for fabricating a color conversion device, an optical device containing at least one color conversion device, method for fabricating a color conversion device and use of a composition.

### Background Art

WO 2017/054898 A1 describes a composition comprising red emission type nanocrystals, wetting and dispersing agent, propylene glycol monomethyl ether acetate as a solvent, an acryl polymer mixture including an acrylic unit including an acid group and a silane modified acrylic unit.

WO 2019/002239 A1 discloses a composition comprising a semiconducting light emitting nanoparticles, a polymer and a (meth)acrylate such as 1.4. cyclohexanedimethanol-monoacrylate having high viscosity around 90 cp.

US 2015/098212 A1 mentions Semiconductor Nanocrystal Composition obtained by mixing pentaerythritol tetrakis(3-mercaptopropionate)(4T), 1,3,5-triallyl-1,3,5-triazine-2,4,6-trione(TTT), and Irgacure 754 and adding the organic additive set forth in Table 1 (paragraphs [0268] - [0269]).

US 2018/102449 A1 discloses the formulation of QD-containing ink compositions including 2-Carboxyethyl acrylate (2CEA) in an amount of 5wt% and octadecylamine-capped core-shell CdSe/ZnS QDs (working example 1).

CN 109535836 A indicates quantum dot ink includes 32 wt% of red light CdSe/CdS/ZnS quantum dots, 26wt% of cyclohexyl butyrate, 34 wt% of 2-methylpropanoic acid cyclohexyl ester, 3wt% of polymethyl methacrylate particles and 5wt% of polyethylene glycol monolaurate (working example 1).

US 2020/017762 A1 describes preparation of curable composition containing a (meth)allyl compound, a (meth) acryl compound, a photopolymerization initiator, and a quantum dot phosphor (Title, examples).

US 2019/218453 A1 mentions a liquid quantum dot composite comprising fluorescent core-shell nanoparticles stabilized with a first ligand of the formula of claim 1.

WO 2016/134820 A1 mentions a photosensitive composition containing red emission type rod-shaped nanocrystals with ligand exchanged Disperbyk®-2000, PGMEA, polymer mixture S1 comprising a polysiloxane - acryl polymer mixture soluble in TMAH aqueous solution, a photo -radical generator OXE01 and OXE02, A-DOD, A-DCP, A-9300 (Working example 1).

WO 2020/208127 A1 discloses indicates an ink composition containing Cd-free QM, TBCH, LA, TMPTA, dispersing agent, scattering beads CR-67 and zirconium beads, photo-initiator (Working examples).

WO 2021/116139 A1 QD ink containing green Cd-free InP based QD, HDDMA: LA monomer mixture, TiO2, photo initiator, and antioxidant (Working examples).

### Patent Literature

1. WO 2017/054898 A1
2. WO 2019/002239 A1
3. US 2015/098212 A1
4. US 2018/102449 A1
5. CN 109535836 A
6. US 2020/017762 A1
7. US 2019/218453 A1
8. WO 2016/134820 A1
9. WO 2020/208127 A1
10. WO 2021/116139 A1


### Summary of the invention

However, the inventors newly have found that there are still one or more of considerable problems for which improvement is desired, as listed below.

Preventing / reducing long term viscosity increase of ink composition, Achiving higher cross-linking density, realizing good compatibility of (meth)acrylate monomers, selecting publically available (meth)acrylate monomers, realizing lower vaper pressure and higher boiling point, achiving a solid film with high polymerization efficiency by QD

containing acrylate ink realising an improved solidity of the film derived by (meth)acrylate monomers under short time and week UV curing condition,

Realizing improved optical properties of bank, improved compatibility between a bank and a composition containing a light emitting moiety (e.g. QD ink), improved wetting properties and chemical stability towards a composition containing a light emitting moiety, less degradation of the bank structure upon bringing the composition containing a light emitting moiety into contact with the bank,

realizing adequate chemical resistance of the bank so that no degradation is observed upon filling the wells of the bank structure with QD Ink, realizing low curing temperature (e.g. 100°C) properties of the bank,

providing a bank having high resolution and/or excellent light shielding properties. Providing a bank composition configured to be developed even with a low-concentration alkaline developer other than an organic developer and is excellent also in environmental properties,

improved homogeneous dispersion of semiconducting light emitting nanoparticles in the composition, improved homogeneous dispersion of scattering particles in the composition, preferably improved homogeneous dispersion of both semiconducting light emitting nanoparticles and scattering particles, more preferably improved homogeneous dispersion of semiconducting light emitting nanoparticles and/or scattering particles without solvent; composition having lower viscosity suitable for inkjet printing, preferably a composition which can keep lower viscosity even if it is mixed with high loading of semiconducting light emitting nanoparticles and/or scattering particles, even more preferably without solvent; composition having lower vaper pressure for large area uniform printing; improved QY and/or EQE of semiconducting light emitting nanoparticles in the composition, improved QY and/or EQE of semiconducting light emitting nanoparticles after printing; improved thermal stability; easy printing without clogging at a printing nozzle; easy handling of the composition, improved printing properties; simple fabrication process; improved absorbance of blue light; improved solidity of a later made from the composition after inkjet printing.

The inventors aimed to solve one or more of the above-mentioned problems.

Then it is found a novel composition as set out in the appended claims.

In another aspect, the present invention relates to a process of fabricating the composition of the present invention comprising at least; essentially consisting of, or consisting of, the following steps Y1 and Y2, preferably in this sequence or Y3;

Y1) mixing at least one light emitting moiety and a (meth)acrylate monomer to form a 1st composition,

Y2) mixing the 1st composition with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group to form the composition of the present invention; or

Y3) mixing at least one light emitting moiety and a (meth)acrylate monomer with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group to form the composition of the present invention.

In another aspect, the present invention relates to use of the composition of the present invention, in an electronic device, optical device, sensing device or in a biomedical device or for fabricating an electronic device, sensing device, optical device or a biomedical device.

In another aspect, the present invention relates to a process of fabricating a layer, wherein the process comprises at least, essentially consisting of or consisting of the following steps;

I) providing a composition of the present invention onto a substrate, preferably

II) curing the composition, preferably said curing is performed by photo irradiation and/or thermal treatment.

In another aspect, the present invention relates to a layer obtained or obtainable from the process.

In another aspect, the present invention further relates to a color conversion device (100) comprising at least, essentially consisting of or consisting of, a 1st pixel (161) partly or fully filled with the layer of the present invention, comprising at least a matrix material (120) containing a light emitting moiety (110), and a bank (150) comprising at least a polymer material, preferably the color conversion device (100) further contains a supporting medium (170).

In another aspect, the present invention further relates to use of the composition of the present invention for

fabricating the layer of the present invention or the device (100) of the present invention.

In another aspect, the present invention furthermore relates to an optical device (300) containing at least one functional medium (320, 420, 520) configured to modulate a light or configured to emit light, and the color conversion device (100) of the present invention.

Further advantages of the present invention will become evident from the following detailed description.

Description of drawings

Fig. 1: shows a cross sectional view of a schematic of one embodiment of a color conversion film (100).

Fig. 2: shows a top view of a schematic of another embodiment of a color conversion film (100) of the invention.

Fig. 3: shows a cross sectional view of a schematic of one embodiment of an optical device (300) of the invention.

Fig. 4: shows a cross sectional view of a schematic of another embodiment of an optical device (300) of the invention.

Fig. 5: shows a cross sectional view of a schematic of another embodiment of an optical device (300) of the invention.

Fig. 6: shows the measurement results of Samples A1 to A3 in working example 5.

Fig. 7: shows the measurement results of Sample B in working example 5.

List of reference signs in figure 1

100. a color conversion device
110. a light emitting moiety
110R. a light emitting moiety (red)
110G. a light emitting moiety (green)
120. a matrix material
130. a light scattering particle (optional)
140. a coloring agent (optional)
140R. a coloring agent (red) (optional)
140G. a coloring agent (green) (optional)
140B. a coloring agent (blue) (optional)
150. a bank
161. a 1st pixel
162. a 2nd pixel
163. a 3rd pixel
170. a supporting medium (a substrate) (optional)

List of reference signs in figure 2

200. a color conversion film
210R. a pixel (red)
210G. a pixel (green)
210B. a pixel (blue)
220. a bank

List of reference signs in figure 3

300. an optical device
100. a color conversion device
110. a light emitting moiety
110R. a light emitting moiety (red)
110G. a light emitting moiety (green)
120. a matrix material
130. a light scattering particle (optional)
140. a coloring agent (optional)
140R. a coloring agent (red) (optional)
140G. a coloring agent (green) (optional)
140B. a coloring agent (blue) (optional)
150. a bank
320. a light modulator
321. a polarizer
322. an electrode
323. a liquid crystal layer
330. a light source
331. a LED light source
332. a light guiding plate (optional)
333. light emission from the light source (330)

List of reference signs in figure 4

400. an optical device
100. a color conversion device
110. a light emitting moiety
110R. a light emitting moiety (red)
110G. a light emitting moiety (green)
120. a matrix material
130. a light scattering particle (optional)
140. a coloring agent (optional)
140R. a coloring agent (red) (optional)
140G. a coloring agent (green) (optional)
140B. a coloring agent (blue) (optional)
150. a bank
420. a light modulator
421. a polarizer
422. an electrode
423. a liquid crystal layer
430. a light source
431. a LED light source
432. a light guiding plate (optional)
440. a color filter
433. light emission from the light source (330)

List of reference signs in figure 5

500. an optical device
100. a color conversion device
110. a light emitting moiety
110R. a light emitting moiety (red)
110G. a light emitting moiety (green)
120. a matrix material
130. a light scattering particle (optional)

140. a coloring agent (optional)
140R. a coloring agent (red) (optional)
140G. a coloring agent (green) (optional)
140B. a coloring agent (blue) (optional)
150. a bank
520. a light emitting device (e.g. OLED)
521. a TFT
522. an electrode (anode)
523. a substrate
524.an electrode (cathode)
525. light emitting layer (e.g. OLED layer(s))
526. light emission from a light emitting device (520)
530. an optical layer (e.g. polarizer) (optional)
540. a color filter

Definition of the terms

In the present specification, symbols, units, abbreviations, and terms have the following meanings unless otherwise specified.

In the present specification, unless otherwise specifically mentioned, the singular form includes the plural form and "one" or "that" means "at least one". In the present specification, unless otherwise specifically mentioned, an element of a concept can be expressed by a plurality of species, and when the amount (for example, mass % or mol %) is described, it means sum of the plurality of species. "And/or" includes a combination of all elements and also includes single use of the element.

In the present specification, when a numerical range is indicated using "to" or " - ", it includes both endpoints and units thereof are common. For example, 5 to 25 mol % means 5 mol % or more and 25 mol % or less.

In the present specification, the hydrocarbon means one including carbon and hydrogen, and optionally including oxygen or nitrogen. The hydrocarbyl group means a monovalent or divalent or higher valent hydrocarbon. In the present specification, the aliphatic hydrocarbon means a linear, branched or cyclic aliphatic hydrocarbon, and the aliphatic hydrocarbon group means a monovalent or divalent or higher valent aliphatic hydrocarbon. The aromatic hydrocarbon means a hydrocarbon comprising an aromatic ring which may optionally not only comprise an aliphatic hydrocarbon group as a substituent but also be condensed with an alicycle. The aromatic hydrocarbon group means a monovalent or divalent or higher valent aromatic hydrocarbon. Further, the aromatic ring means a hydrocarbon comprising a conjugated unsaturated ring structure, and the alicycle means a hydrocarbon having a ring structure but comprising no conjugated unsaturated ring structure.

In the present specification, the alkyl means a group obtained by removing any one hydrogen from a linear or branched, saturated hydrocarbon and includes a linear alkyl and branched alkyl, and the cycloalkyl means a group obtained by removing one hydrogen from a saturated hydrocarbon comprising a cyclic structure and optionally includes a linear or branched alkyl in the cyclic structure as a side chain.

In the present specification, the aryl means a group obtained by removing any one hydrogen from an aromatic hydrocarbon. The alkylene means a group obtained by removing any two hydrogens from a linear or branched, saturated hydrocarbon. The arylene means a hydrocarbon group obtained by removing any two hydrogens from an aromatic hydrocarbon.

In the present specification, the descriptions such as "$C_{x-y}$", "$C_x$-$C_y$" and "$C_x$" mean the number of carbons in the molecule or substituent group. For example, $C_{1-6}$ alkyl means alkyl having 1 to 6 carbons (such as methyl, ethyl, propyl, butyl, pentyl and hexyl). Further, the fluoroalkyl as used in the present specification refers to one in which one or more hydrogen in alkyl is replaced with fluorine, and the fluoroaryl is one in which one or more hydrogen in aryl are replaced with fluorine.

In the present specification, when polymer has a plural types of repeating units, these repeating units copolymerize. These copolymerization are any of alternating copolymerization, random copolymerization, block copolymerization, graft copolymerization, or a mixture of any of these.

In the present specification, "%" represents mass % and "ratio" represents ratio by mass.

In the present specification, Celsius is used as the temperature unit. For example, 20 degrees means 20 degrees Celsius.

Detailed description of the invention

According to the present invention, in one aspect, the composition comprises, essentially consisting of or

consisting of;

i) a (meth)acrylate monomer;
ii) a light emitting moiety; and
iii) a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphate group, a phosphonate group, thiol group, a carboxyl group or a combination of any of these, more preferably it is a carboxyl group.

It is believed that a phosphonate group, thiol group, a carboxyl group or a combination of any of these are more preferable since it has better attaching ability to the outer most surface of the inorganic part of the light emitting moiety (such as the surface of the inorganic part of quantum materials).

Here, the term "(meth)acrylate" is a general term for an acrylate and a methacrylate. Therefore, accroding to the present invention, the term "(meth)acrylate monomer" means a methacrylate monomer and/or a acrylate monomer.

In a preferred embodiment of the present invention, said chemical compound further comprises at least one straight-chain or branched alkyl group having carbon atoms 1 to 45, straight-chain or branched alkenyl group having carbon atoms 1 to 45 or straight-chain or branched alkoxyl group having carbon atoms 1 to 45, preferably said carbon atoms of the alkyl group, the alkenyl group and/or the alkoxy group are in the range from 5 to 35, more preferably it is from 10 to 25, even more preferably from 12 to 24, furthermore preferably it is from 14 to 20 and preferably said alkyl group, alkenyl group and/or alkoxy group may be substituted or unsubstituted.

It is believed that it is preferable to control viscosity/solubility of the composition accrodingly. More preferably it can prevent increasement of visicosity of the composition and/or keeping a good solubility of the light luminescent moietys in a long term strage in the composition.

According to the present invention, the chemical compound is represented by following chemical formula ($X^A$).

Z-Y - ($X^A$)

wherein

Z is *- $R^{x1}$ or

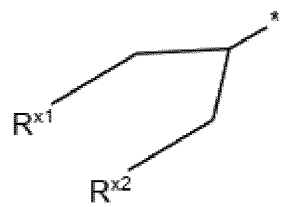

,

where "*" represents the connecting point to symbol Y of the formula, $R^{x1}$ is a group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group; and

$R^{x2}$ is a group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group;

Y is a straight-chain or branched alkyl group having carbon atoms 1 to 45, straight-chain or branched alkenyl group having carbon atoms 1 to 45 or straight-chain or branched alkoxyl group having carbon atoms 1 to 45, preferably said carbon atoms of the alkyl group, the alkenyl group and/or the alkoxy group are in the range from 5 to 35, more preferably it is from 10 to 25, even more preferably from 12 to 24, furthermore preferably it is from 14 to 20 and preferably said alkyl group, which may be substituted by one or more radicals $R^a$, where one or more non-adjacent $CH_2$ groups may be replaced by $R^aC=CR^a$, $C\equiv C$, $Si(R^a)_2$, $Ge(R^a)_2$, $Sn(R^a)_2$, C=O, C=S, C=Se, $C=NR^a$, $P(=O)(R^a)$,

SO, SO2, $NR^a$, OS, or $CONR^a$ and where one or more H atoms may be replaced by D, F, Cl, Br, I, CN or $NO_2$,

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another.

Preferable embodiments of the chemical compound can be selected from stearic acid, oleic acid, parmitic acid, dodecenoic acid, octadecylphosphonic acid, hexylphosphonic acid, monostearyl phosphate, didodecyl phosphate, monododecyl phosphate, didodecyl phosphate, their derivatives and a combination of any of these.

In a preferable embodiment of the present invention, the ratio of the total weight of the chemical compound to the total weight of the light emitting moiety is in the range 0.6:40 to 1:3, preferably it is from 1:40 to 1:2, more preferably from 1.5:40 to 1:1; in case of said light emitting moiety is an inorganic light emitting material, the ratio of the weight of the chemical compound to the weight of the inorganic part of the inorganic light luminescent material is in the range from 0.003 to 3.2, preferably from 0.006 to 2.8, more preferably from 0.015 to 1.3.

It is believed that said weight ratio of the chemical compound is very preferable to control viscosity/solubility of the composition accrodingly. And it is very preferable to prevent increasement of visicosity of the composition and/or keeping a good solubility of the light luminescent moietys in a long term strage in the composition.

- The composition and (meth)acrylate monomer

According to the present invention, the composition, comprises at least

i) one (meth)acrylate monomer represented by following chemical formula (I) together with ii) a light emitting moiety and iii) the chemical compound.

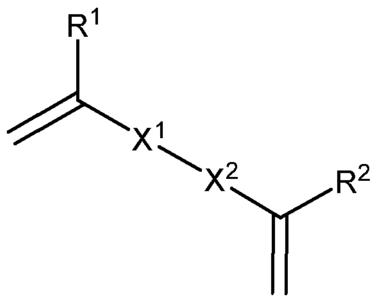

(I)

wherein

$R^1$ is a hydrogen atom, halogen atom of Cl, Br, or F, methyl group, alkyl group, aryl group, alkoxy group, ester group, or a carboxylic acid group;

$R^2$ is a hydrogen atom, halogen atom of Cl, Br, or F, methyl group, alkyl group, aryl group, alkoxy group, ester group, or a carboxylic acid group;

the symbol $X^1$ is

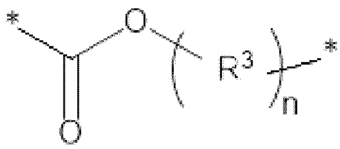

,

where "*" on the left side of the formula represents the connecting point to the carbon atom of the end group $C=CR^1$ of the formula (I) and "*" on the right side represents the connecting point to symbol $X^2$ of the formula (I); n is 0 or 1;

the symbol $X^2$ is

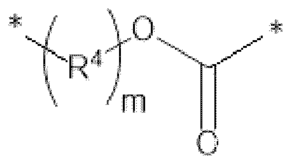

,

**where** "*" on the left side of the formula represents the connecting point to symbol X1 of the formula (I) and "*" on the right side represents the connecting point to the end group $C=CR^2$ of the formula (I);

m is 0 or 1;

preferably at least m or n is 1;

$R^3$ is a straight alkylene chain or alkoxylene chain having 1 to 25 carbon atoms, a cycloalkane having 3 to 25 carbon atoms or an aryl group having 3 to 25 carbon atoms, preferably $R^3$ is a straight alkylene chain or alkoxylene chain having1 to 15 carbon atoms, more preferably 1 to 5 carbon atoms,

which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^4$ is a straight alkylene chain or alkoxylene chain having 1 to 25 carbon atoms, a cycloalkane having 3 to 25 carbon atoms or an aryl group having 3 to 25 carbon atoms, preferably $R^4$ is a straight alkylene chain or alkoxylene chain having1 to 15 carbon atoms, more preferably 1 to 5 carbon atoms,

which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another.

In a preferred embodiment of the present invention, the viscosity of the composition is 35 cP or less at room temperature, preferably in the range from 1 to 35 cP, more preferably from 2 to 30 cP, even more preferably from 2 to 25 cP.

According to the present invention, said viscosity can be measured by vibration type viscometer VM-10A (SEKONIC) at room temperature. https://www.sekonic.co.jp/english/product/viscometer/vm/vm_series.html - (Meth) acrylate monomer represented by chemical formula (I) as a matrix material

It is believed that the lower viscosity is important to make a low viscosity composition suitable for inkjet printing. Therefore, a (meth)acrylate monomer having the viscosity value within the above-mentioned parameter ranges are especially suitable to make a composition for inkjet printing. By using these (meth)acrylate monomer in a composition, when it is mixed with another material such as semiconducting light emitting nanoparticles with high loading, the composition can still keep lower viscosity within the range suitable for inkjet printing.

In a preferred embodiment of the present invention, the boiling point (B.P.) of said (meth)acrylate monomer of chemical formula (I) is 250°C or more, preferably it is in the range from 250°C to 350°C, even more preferably from 280°C to 350°C, further more preferably from 300°C to 348°C. for large area uniform inkjet printing.

It is believed that said high boiling point is also important to make a composition having a lower vapor pressure preferably less than 0.001mmHg for large area uniform printing, it is preferable to use a (meth)acrylate monomer of formula (I) having the viscosity value of 25 cP or less at 25°C and the boiling point at least 250°C or more, preferably it is in the range from 250°C to 350°C, more preferably from 300°C to 348°C to make a composition suitable for large area uniform inkjet printing even if it is mixed with high loading of another materials such as high loading of semiconducting light emitting nanoparticles.

According to the present invention, said B.P can be estimate by the known method such as like described in

Science of Petroleum, Vol.II. p.1281 (1398), https://www.sigmaaldrich.com/chemistry/solvents/learning-center/nomograph.html.

According to the present invention, any types of publicly available acrylates and / or methacrylates represented by chemical formula (I) can be used preferably.

Especially for the first aspect, any types of publicly available acrylates and / or methacrylates having the viscosity value of 25 cP or less at 25°C represented by chemical formula (I) can be used.

Furthermore preferably, said $R^3$ of formula (I) and $R^4$ of formula (I) are, each independently of each other, selected from the following groups, wherein the groups can be substituted with $R^a$, preferably they are unsubstituted by $R^a$.

| | | |
|---|---|---|
| $*-(CH_2)_1-*$ | $*-(CH_2)_2-*$ | $*-(CH_2)_3-*$ |
| $*-(CH_2)_4-*$ | $*-(CH_2)_5-*$ | $*-(CH_2)_6-*$ |
| $*-(CH_2)_7-*$ | 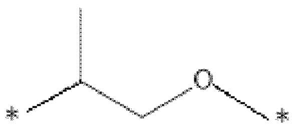 | 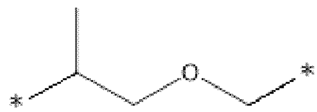 |
| 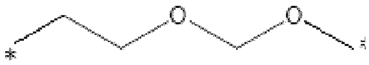 | 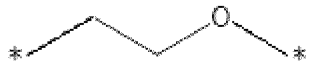 | 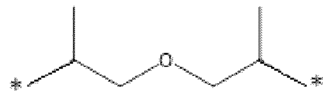 |
| 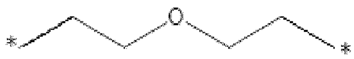 | 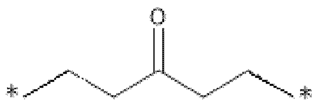 | 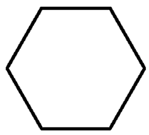 |
| 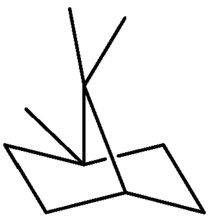 | 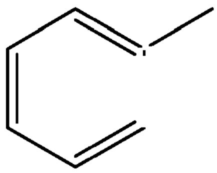 | 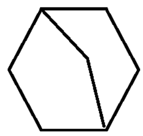 |
| 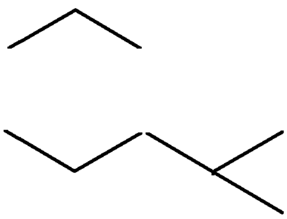 | 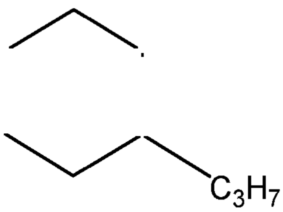 | 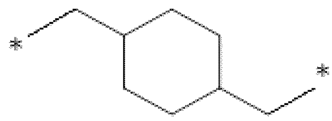 |
| 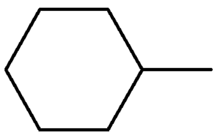 | 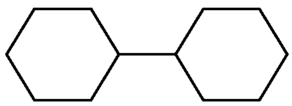 | 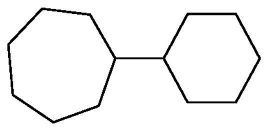 |
| 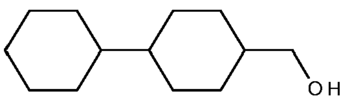 | 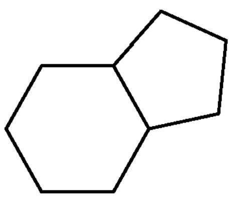 | 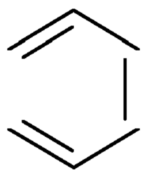 |

(continued)

| | | |
|---|---|---|
| 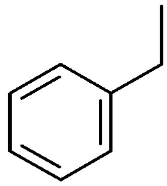 | 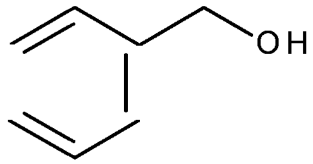 | 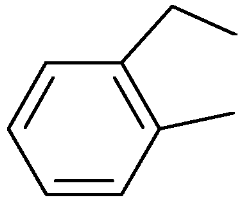 |
| 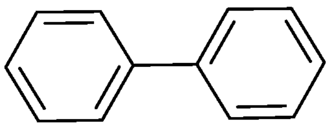 | 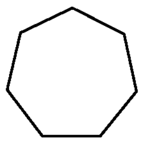 | 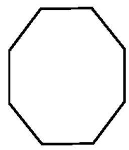 |
| 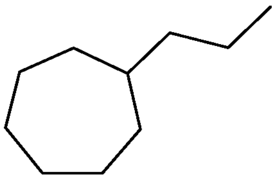 | 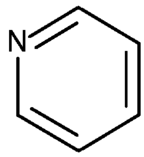 | 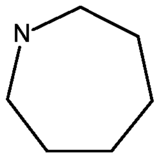 |
| 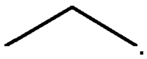 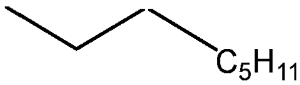 | | |

Particularly preferably, said $R^3$ and $R^4$ of formula (I) are, at each occurrence, independently or differently, selected from the following groups.

| | | |
|---|---|---|
| *-$(CH_2)_1$-* | *-$(CH_2)_2$-* | *-$(CH_2)_3$-* |
| *-$(CH_2)_4$-* | *-$(CH_2)_5$-* | *-$(CH_2)_6$-* |
| *-$(CH_2)_7$-* | 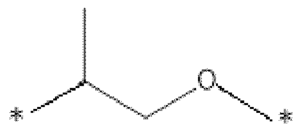 | 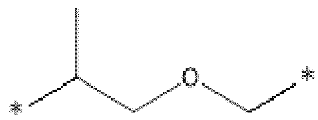 |
| 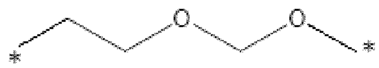 | 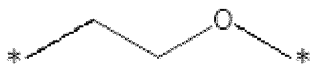 | 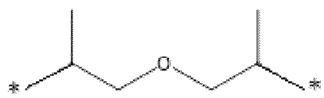 |

wherein "*" represents the connecting point to oxygen atom of the formula or the connecting point to $X^2$ of the formula in case of $R^3$, and wherein "*" represents the connecting point to oxygen atom of the formula or the connecting point to $X^1$ of the formula in case of $R^4$.

Furthermore preferably, said formula (I) is NDDA (BP:342°C), HDDMA (BP:307) or DPGDA (BP: 314°C).

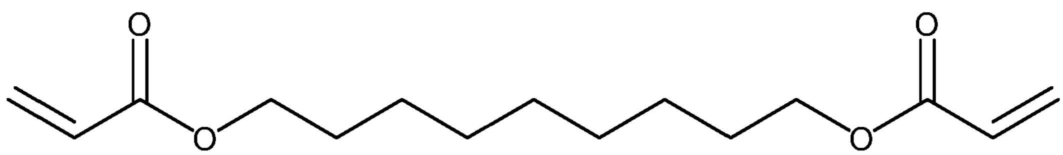

(NDDA)

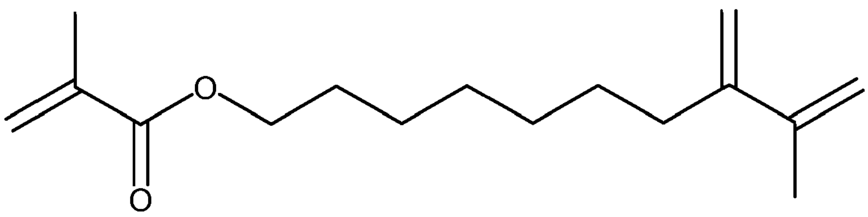

(HDDMA)

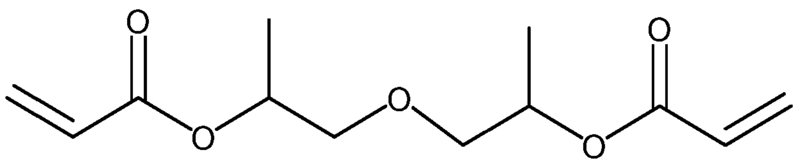

(DPGDA)

According to the present invention, the composition further comprises another (meth)acrylate monomer represented by following chemical formula (II);

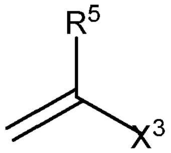

(II)

$X^3$ is a non-substituted or substituted alkyl group, aryl group or an alkoxy group;

the symbol $X^3$ is

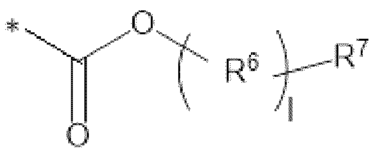

,

where "*" on the left side of the formula represents the connecting point to the end group $C=CR^5$ of the formula (I);

I is 0 or 1;

$R^5$ is a hydrogen atom, halogen atom of Cl, Br, or F, methyl group, alkyl group, aryl group, alkoxy group, ester group, or a carboxylic acid group;

$R^6$ is a straight alkylene chain or alkoxylene chain having 1 to 25 carbon atoms, preferably $R^6$ is a straight alkylene chain or alkoxylene chain having1 to 15 carbon atoms, more preferably 1 to 5 carbon atoms, which may be substituted by one or more radicals $R^a$, where one or more non-adjacent $CH_2$ groups may be replaced by $R^aC=CR^a$, C≡C, $Si(R^a)_2$, $Ge(R^a)_2$, $Sn(R^a)_2$, C=O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^7$ is a straight alkylene chain or alkoxylene chain having 1 to 25 carbon atoms, preferably $R^7$ is a straight alkylene chain or alkoxylene chain having1 to 15 carbon atoms, more preferably 1 to 5 carbon atoms, which may be substituted by one or more radicals $R^a$, where one or more non-adjacent $CH_2$ groups may be replaced by $R^aC=CR^a$, C=C, $Si(R^a)_2$, $Ge(R^a)_2$, $Sn(R^a)_2$, C=O, C=S, C=Se, $C=NR^a$, $P(=O)(R^a)$, SO, SO2, $NR^a$, OS, or $CONR^a$ and where one or more H atoms may be replaced by D, F, Cl, Br, I, CN or $NO_2$;

$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more

adjacent substituents $R^a$ here may also form a mono- or polycyclic, aliphatic, aromatic or heteroaromatic ring system with one another.

- (Meth)acrylate monomer represented by chemical formula (II)

It is believed that the (meth)acrylate monomer represented by following chemical formula (II) shows much lower viscosity value than the viscosity of the (meth)acrylate monomer of formula (I). Thus, by using the (meth)acrylate monomer represented by chemical formula (II) in combination of the (meth)acrylate monomer of chemical formula (I), a composition having much lower viscosity desirable for smooth inkjet printing can be realized, preferably without decreasing External Quantum Efficiency (EQE) value.

It is believed that said combination can realize a low viscosity composition comprising high amount of another materials, such as high loading of semiconducting light emitting nanoparticles. Thus, it is especially suitable for an inkjet printing when the composition comprises another material.

In a preferable embodiment of the present invention, the boiling point (B.P.) of said (meth)acrylate monomer of chemical formula (II) is 250°C or more, preferably the (meth)acrylate monomer of chemical formula (II) is 250°C or more, more preferably it is in the range from 250°C to 350°C, even more preferably from 280°C to 350°C, further more preferably from 300°C to 348°C for large area uniform inkjet printing.

In a further preferable embodiment of the present invention, the boiling point (B.P.) of said (meth)acrylate monomer of chemical formula (I) and/or the boiling point (B.P.) of said (meth)acrylate monomer of chemical formula (II) is 250°C or more, preferably the (meth)acrylate monomers of chemical formula (I) and chemical formula (II) are both 250°C or more, more preferably it is in the range from 250°C to 350°C, even more preferably from 280°C to 350°C, further more preferably from 300°C to 348°C. for large area uniform inkjet printing.

Furthermore preferably, said $R^7$ of formula (II) is, at each occurrence, independently or differently, selected from the following groups, wherein the groups can be substituted with $R^a$, preferably they are unsubstituted by $R^a$.

| | | |
|---|---|---|
| *-$(CH_2)_6$-$CH_3$ | *- $(CH_2)_7$-$CH_3$ | *-$(CH_2)_8$-$CH_3$ |
| *-$(CH_2)_9$-$CH_3$ | *-$(CH_2)_{10}$-$CH_3$ | *-$(CH_2)_{11}$-$CH_3$ |
| *-$(CH_2)_{12}$-$CH_3$ | *-$(CH_2)_4$-OH | *-$(CH_2)_2$-OH |
| *-$(CH_2)_6$-OH | *-$(CH_2)_3$-OH | *-$(CH_2)_5$-OH |

wherein "*" represents the connecting point to $R^6$ of $X^3$ in case l is 1, and it is representing the connecting point to oxygen atom of $X^3$ of the formula (II) in case n is 0.

The furthermore preferably, said formula (II) is Lauryl methacrylate (LM, viscosity 6 cP, BP: 142°C) or Lauryl acrylate (LA, viscosity: 4.0cP, BP: 313.2°C).

In a preferred embodiment of the present invention, the (meth)acrylate monomer of chemical formula (II) is in the composition and the mixing ratio of the (meth)acrylate monomer of chemical formula (I) to the (meth)acrylate monomer of chemical formula (II) is in the range from 1:99 to 99:1 (formula (I) : formula (II)), preferably from 5:95 to 50:50, more preferably from 10:90 to 40:60, even more preferably it is from 15:85 to 35:65, preferably at least a purified (meth)acrylate monomer represented by chemical formula (I), (II) is used in the composition, more preferably the (meth)acrylate monomer of chemical formula (I) and the (meth)acrylate monomer of chemical formula (II) are both obtained or obtainable by a purification method.

It is believed that the higher amount of the (meth)acrylate monomer of chemical formula (II) to the total amount of the (meth)acrylate monomer of chemical formula (I) leads improved EQE of the composition, and the mixing weight ratio of the (meth)acrylate monomer of chemical formula (II) to the total amount of the (meth)acrylate monomer of chemical formula (I) less than 50 wt.% is preferable from the view point of viscosity of the composition, better ink-jetting properties of the composition.

Preferably, (meth)acrylate monomers purified by using silica column are used.

It is believed that an impurity removal from the (meth)acrylate monomers by the silica column purification leads improved QY of the semiconducting light emitting nanoparticle in the composition.

In some embodiments of the present invention, the composition further comprises a (meth)acrylate monomer represented by following chemical formula (III);

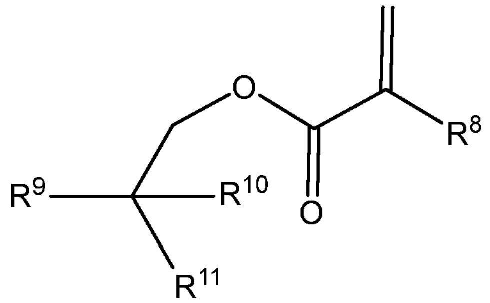

(III);

wherein $R^9$ is hydrogen atom, a straight alkyl group having 1 to 25 carbon atoms or a (meth)acryl group represented by chemical formula (IV)

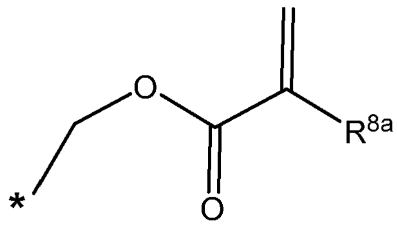

(IV);

$R^{10}$ is hydrogen atom, a straight alkyl group having 1 to 25 carbon atoms or a (meth)acryl group represented by chemical formula (V)

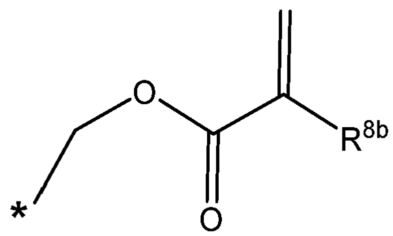

(V);

$R^{11}$ is hydrogen atom, a straight alkyl group having 1 to 25 carbon atoms or a (meth)acryl group represented by chemical formula (VI)

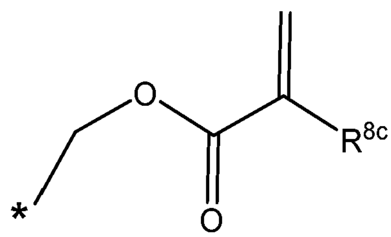

(VI);

wherein $R^{8a}$, $R^{8b}$ and $R^{8c}$ are, each independently or dependently of each other at each occurrence, H or $CH_3$; wherein at least one of $R^9$, $R^{10}$ and $R^{11}$ is a (meth)acryl group, preferably two of $R^9$, $R^{10}$ and $R^{11}$ are a (meth)acryl group and other one is a hydrogen atom or a straight alkyl group having 1 to 25 carbon atoms, preferably the electric conductivity (S/cm) of the (meth)acrylate monomer of formula (III) is $1.0*10^{-10}$ or less, preferably it is $5.0*10^{-11}$ or less, more preferably it is in the range from $5.0*10^{-11}$ to $1.0*10^{-15}$, even more preferably it is in the range from $5.0*10^{-12}$ to $1.0*10^{-15}$.

It is believed that the (meth)acrylate monomer of chemical formula (III) is useful to improve its solidity of a later made from the composition after inkjet printing.

According to the present invention, a publicly known a (meth)acrylate monomer represented by following chemical formula (III) can be used to improve solidity of a layer after inkjet printing and cross linking.

Very preferably, Trimethylolpropane Triacrylate (TMPTA) is used as the (meth)acrylate monomer of chemical formula (III).

In a preferable embodiment of the present invention, the amount of the (meth)acrylate monomer of chemical formula (III) based on the total amount of (meth)acrylate monomers in the composition is in the range from 0.001 wt.% to 25wt.%, more preferably in the range from 0.1wt.% to 15wt. %, even more preferably from 1wt.% to 10wt.%, further more preferably from 3 to 7wt%.

Preferably, there (meth)acrylate monomers are purified by using silica column, are used.

It is believed that an impurity removal from the (meth)acrylate monomers by the silica column purification leads improved QY of the semiconducting light emitting nanoparticle in the composition.

It is believed that said (meth)acrylate monomer represented by chemical formula (III), especially TMPTA, is preferable due to [1] high cross-linking density even with small loading [2]compatibility to the (meth)acrylate monomer represented by Chemical formula (II), especialy to LA, [3] publical availability, [4] lower vaper pressure and [5] higher boiling point of the monomer. Regarding [1], acryl group as reacitve group is preferably selected because aclyrate has higher reaction speed than (meth)acrylate and other double bond structures. QD containing acrylate ink can achieve solid film with high polymerization efficiency by selecting said monomer of chemical formula (III). It is also believed solidity of the film derived by said (meth)acrylate monomer represented by chemical formula (III) and (meth)acrylate monomer represented by chemical formula (II) is preferable even if the printed composition containing a (meth)acrylate monomer represented by chemical formula (III) and a (meth)acrylate monomer represented by chemical formula (II) is cured under short and week UV curing condition.

In a preferable embodiment, the mixing ratio of the (meth)acrylate monomer of chemical formula (III) to the (meth) acrylate monomer of chemical formula (II) is in the range from 1:99 to 99:1 (formula (III) : formula (II)), preferably from 5:95 to 50:50, more preferably from 10:90 to 40:60, even more preferably it is from 15:85 to 35:65, preferably at least a purified (meth)acrylate monomer represented by chemical formula (III), (II) is used in the composition, more preferably the (meth) acrylate monomer of chemical formula (III) and the (meth)acrylate monomer of chemical formula (II) are both obtained or obtainable by a purification method.

According to the present invention, the composition is configured to show the EQE value 23% or more, preferably 24% or more and less than 95%.

According to the present invention, said EQE is measured by the following EQE measurement process at room temperature which is based on using an integrating sphere, equipped with a 450nm excitation light source coupled in via an optical fiber, and a spectrometer (C9920, Hamamatsu photonics), and which consists of a first measurement using air as the reference to detect the incident photons of the excitation light and a second measurement with the sample or test cell placed in front of the integrating sphere in between the opening of the integrating sphere and the exit of the optical fiber to detect the photons incident from the excitation light source transmitted through the sample and the photos emitted from the sample or test cell, whereas for both cases photons exiting the integrating sphere are counted by the spectrometer and EQE and BL calculation is done with the following equations and the number of photons of the excitation light and emission light is calculated by integration over the following wavelength ranges;

EQE = Photons [Emission light] / Photons [Excitation light measured without sample in place];

BL = Photons [measured without sample in place] / Photons [Excitation light measured without sample in place];

Emission light if green light emitting moieties are used: 480nm-600nm,
Emission light if red light emitting moieties are used: 560nm-680nm
Excitation light: 430nm-470nm .

According to the present invention, in a preferred embodiment, the viscosity of the composition is 35 cP or less at room temperature, preferably in the range from 1 to 35 cP, more preferably from 2 to 30 cP, even more preferably from 2 to 25 cP.

In a preferred embodiment of the present invention, the composition comprises a solvent 10wt% or less based on the total amount of the composition, more preferably it is 5wt% or less, more preferably it is a solvent free composition, preferably the composition does not comprise any one of the following solvent selected from one or more members of the group consisting of ethylene glycol monoalkyl ethers, such as, ethylene glycol monomethyl ether, ethylene glycol monoethyl ether, ethylene glycol monopropyl ether, and ethylene glycol monobutyl ether; diethylene glycol dialkyl ethers, such as, diethylene glycol dimethyl ether, diethylene glycol diethyl ether, diethylene glycol dipropyl ether, and diethylene

glycol dibutyl ether; propylene glycol monoalkyl ethers, such as, propylene glycol monomethyl ether(PGME), propylene glycol monoethyl ether, and propylene glycol monopropyl ether; ethylene glycol alkyl ether acetates, such as, methyl cellosolve acetate and ethyl cellosolve acetate; propylene glycol alkyl ether acetates, such as, propylene glycol monomethyl ether acetate (PGMEA), propylene glycol monoethyl ether acetate, and propylene glycol monopropyl ether acetate; ketones, such as, methyl ethyl ketone, acetone, methyl amyl ketone, methyl isobutyl ketone, and cyclohexanone; alcohols, such as, ethanol, propanol, butanol, hexanol, cyclo hexanol, ethylene glycol, triethylene glycol and glycerin; esters, such as, ethyl 3-ethoxypropionate, methyl 3-methoxypropionate and ethyl lactate; and cyclic asters, such as, gamma-butyro-lactone; chlorinated hydrocarbons, such as chloroform, dichloromethane, chlorobenzene, trimethyl benzenes such as 1,3,5-trimethylbenzene, 1,2,4-trimethyl benzene, 1,2,3-trimethyl benzene, docecylbenzene, cyclohexylbenzene, 1,2,3,4-tetramethylbenzene, 1,2,3,5-tetramethylbenzene, 3-isopropylbiphenyl, 3-methylbiphenyl, 4-methylbiphenyl and dichlorobenzene, preferably said solvent is propylene glycol alkyl ether acetates, alkyl acetates, ethylene glycol monoalkyl ethers, propylene glycol, and propylene glycol monoalkyl ethers.

**It** is believed that the less than 10wt% of solvent in the composition leads improved ink-jetting and it can avoid $2^{nd}$ or more ink-jetting onto the same pixel after evaporation of the solvent.

According to the present invention, it is desirable not to add any solvent to realize large area inkjet printing with improved uniformity without causing any clogging at a nozzle and/or with good dispersity of semiconducting light emitting nanoparticles and/or with good dispersity of scattering particles.

According to the present invention, preferably the composition further comprises an another material selected from one or more members of the group consisting of;

iii) at least one semiconducting light emitting nanoparticle comprising a $1^{st}$ semiconducting nanoparticle, optionally one or more shell layers covering at least a part of the $1^{st}$ semiconducting nanoparticle, preferably said nanoparticle comprises a ligand, more preferably said nanoparticle comprises a alkyl type ligand having carbon atoms 2 to 25, preferably from 6 to 15 (such as C12, C8);

iv) another (meth)acrylate monomer, preferably it is different from the (meth)acrylate monomer of chemical formula (I), more preferably it is different from the (meth)acrylate monomer of chemical formula (I) and (II);

v) scattering particles, and

vi) optically transparent polymers, anti-oxidants, radical quenchers, photo initiators and/or surfactants.

**In** some embodiments of the present invention, preferably the composition of the present invention comprises

v) scattering particles; and

vii) at least one polymer configured so that said polymer enables to the scattering particles to disperse in the composition;

wherein the polymer comprises at least a phosphine group, phosphine oxide group, phosphate group, phosphonate group, thiol group, tertiary amine, carboxyl group, hetero cyclic group, silane group, sulfonic acid, hydroxyl group, phosphonic acid, or a combination of thereof, preferably the polymer comprises a tertiary amine, phosphine oxide group, phosphonic acid, or a phosphate group.

According to the present invention, the polymer configured so that said polymer enables to the scattering particles to disperse in the composition comprises at least a repeating unit A comprising a phosphine group, phosphine oxide group, phosphate group, phosphonate group, thiol group, tertiary amine, carboxyl group, hetero cyclic group, silane group, sulfonic acid, hydroxyl group, phosphonic acid, or a combination of thereof, preferably the repeating unit A comprises a tertiary amine, phosphine oxide group, phosphonic acid, or a phosphate group.

**In** some embodiments of the present invention, the repeating unit A and the repeating unit B are a constitutional repeating unit.

Even more preferably, the repeating unit A comprises a tertiary amine represented by following chemical formula (VII),

$$NR^{12}R^{13}R^{14}\text{- -} \qquad \text{(VII)}$$

wherein $R^{12}$ is a hydrogen atom, a straight or a branched alkyl group having 1 to 30 carbon atoms, or an aryl group having 1 to 30 carbon atoms; $R^{13}$ is a hydrogen atom, a straight or a branched alkyl group having 1 to 30 carbon atoms, or an aryl

group having 1 to 30 carbon atoms; $R^{12}$ and $R^{13}$ can be same or different of each other; $R^{14}$ is a single bond, a straight or a branched alkylene group having 1 to 30 carbon atoms, alkenylene group having 1 to 30 carbon atoms, (poly)oxaalkylene group having 1 to 30 carbon atoms.

Even more preferably, $R^{12}$ is a straight or a branched alkyl group having 1 to 30 carbon atoms; $R^{13}$ is a straight or a branched alkyl group having 1 to 30 carbon atoms; $R^{12}$ and $R^{13}$ can be same or different of each other.

Furthermore preferably, $R^{12}$ is methyl group, ethyl group, n-propyl group, or n-butyl group; $R^{13}$ is methyl group, ethyl group, n-propyl group, or n-butyl group.

According to the present invention, in a preferred embodiment, the repeating unit A does not contain a salt.

In a preferred embodiment of the present invention, the polymer is a copolymer selected from the group consisting of graft copolymers, block copolymers, alternating copolymers, and random copolymers, preferably said copolymer comprises the repeating unit A, and repeating unit B that does not include any phosphine group, phosphine oxide group, phosphate group, phosphonate group, thiol group, tertiary amine, carboxyl group, hetero cyclic group, silane group, sulfonic acid, hydroxyl group, phosphonic acid, and a combination of thereof, more preferably the copolymer is a block copolymer represented by following chemical formula (VIII) or (IX),

$$A_n - B_m - \qquad (VIII)$$

$$B_o - A_n - B_m - \qquad (IX)$$

wherein the symbol "A" represents a repeating unit A; the symbol "B" is taken to mean the repeating unit B; the symbols "n", "m", and "o" are at each occurrence, independently or dependently of each other, integers 1 to 100, preferably 5 to 75, more preferably 7 to 50; even more preferably the repeating unit B comprises a polymer chain selected from the group consisting of (poly)ethylene, (poly)phenylene, polydivinylbenzene, (poly)ethers, (poly)esters, (poly)amides, (poly)urethanes, (poly) carbonates, polylactic acids, (poly)vinyl esters, (poly)vinyl ethers, polyvinyl alcohols, polyvinylpyrrolidones, celluloses and derivatives of any of these.

In a preferred embodiment of the present invention, the polymer chain of the repeating unit B is a polyethylene glycol.

More preferably, the repeating unit B comprises a chemical structure represented by following chemical formula (X),

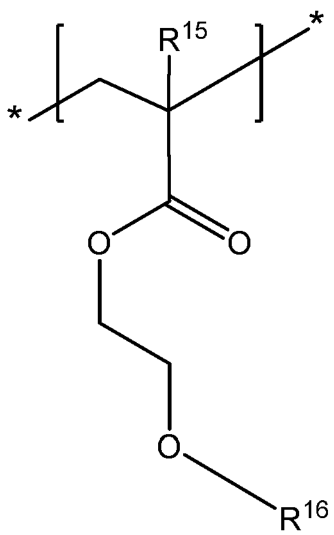

Chemical formula (X)

wherein the chemical formula (X), $R^{15}$ is hydrogen atom, or methyl group; $R^{16}$ is alkyl group having 1 to 10 carbon atoms; and n is an integer 1 to 5, "*" represents the connecting point to an another polymer repeating unit or a terminal of the polymer.

Even more preferably, $R^{15}$ can be a hydrogen atom, or methyl group, $R^{16}$ can be an ethyl group, and n is an integer 1 to 5.

In some embodiments of the present invention, the surface of the core, or the outermost surface of one or more shell layers of the semiconducting light emitting nanoparticle can be partly or fully over coated by the polymer. By using ligand exchange method, described in for example, Thomas Nann, Chem. Commun., 2005, 1735 - 1736, DOI: 10.1039/b-414807j, the polymer can be introduced onto the surface of the core or the outermost surface of the core of the semiconducting light emitting nanoparticle.

According to the present invention, in some embodiments, the content of said polymer is in the range from 1% to 500% by weight, more preferably in the range from 20% to 350% by weight, even more preferably from 50% to 200% by weight with respect to the total weight of the semiconducting light emitting nanoparticle.

In a preferred embodiment of the present invention, the weight average molecular weight (Mw) of the polymer is in the range from 200 g/mol to 30,000 g/mol, preferably from 250 g/mol to 2,000 g/mol, more preferably from 400 g/mol to 1,000 g/mol.

The molecular weight $M_w$ is determined by means of GPC (= gel permeation chromatography) against an internal polystyrene standard.

As the polymer, commercially available wetting and dispersing additives which can be solved in non-polar and / or low polar organic solvent can be used preferably. Such as BYK-111, BYK-LPN6919, BYK-103, BYK-P104, BYK-163 ([trademark], from BYK com.), TERPLUS MD1000 series, such as MD1000, MD1100 ([trademark], from Otsuka Chemical), Poly(ethylene glycol) methyl ether amine (Sigma-Ald 767565 [trademark], from Sigma Aldrich), Polyester bis-MPA dendron, 32 hydroxyl, 1 thiol, (Sigma-Ald 767115 [trademark], from Sigma Aldrich), LIPONOL DA-T/25 (From Lion Specialty Chemicals Co.), Carboxymethyl cellulose (from Polyscience etc.), another wetting and dispersing additives disclosed in for examples, "Marc Thiry et. al., ACSNANO, American Chemical society, Vol. 5, No. 6, pp 4965 - 4973, 2011", "Kimihiro Susumu, et. al., J. Am. Chem. Soc. 2011, 133, pp 9480-9496".

Thus, in some embodiments of the present invention, the composition comprises at least the (meth)acrylate monomer of chemical formula (I), the (meth)acrylate monomer of chemical formula (II) and the polymer configured so that said polymer enables to the scattering particles to disperse in the composition, wherein the mixing ratio of the (meth) acrylate monomer of chemical formula (I): the (meth)acrylate monomer of chemical formula (II) : the polymer is 10:89:1 to 50:40:10, preferably in the range from 15:82:3 to 30:60:10.

In some embodiment of the present invention, a composition comprises, essentially consisting of or consisting of, at least a polymer derived or derivable from the (meth)acrylate monomers of the composition of the present invention.

In a preferred embodiment of the present invention, said polymer is derived or derivable from all the (meth) acrylate monomers in the composition, for example, at least the (meth)acrylate monomer of chemical formula (I) and/or the (meth)acrylate monomer of chemical formula (II).

v) Scattering particles

According to the present invention, as the scattering particles, publicly known small particles of inorganic oxides such as $SiO_2$, $SnO_2$, CuO, CoO, $Al_2O_3$ $TiO_2$, $Fe_2O_3$, $Y_2O_3$, ZnO, ZnS, MgO; organic particles such as polymerized polystyrene, polymerized PMMA; inorganic hollow oxides such as hollow silica or a combination of any of these; can be used. The amount of the scattering particles is preferably 4wt% or less based on the total amount of the solid contents of the layer, preferably it is in the range from 4 to 0wt%, more preferably it is in the range from 1 to 0wt%, more preferably the layer and/or the composition does not contain any scattering particles.

In some embodiments of the present invention, the composition comprises iii) at least one semiconducting light emitting nanoparticle comprising a 1$^{st}$ semiconducting nanoparticle, optionally one or more shell layers covering at least a part of the 1$^{st}$ semiconducting nanoparticle, preferably the composition has EQE value 23% or more, preferably 24% or more and less than 95%.

According to the present invention, as a transparent polymer, a wide variety of publicly known transparent polymers suitable for optical devices, described in for example, WO 2016/134820A can be used preferably.

According to the present invention, the term "transparent" means at least around 60 % of incident light transmit at the thickness used in an optical medium and at a wavelength or a range of wavelength used during operation of an optical medium. Preferably, it is over 70 %, more preferably, over 75%, the most preferably, it is over 80 %.

According to the present invention the term "polymer" means a material having a repeating unit and having the weight average molecular weight (Mw) 1000 g/mol, or more.

The molecular weight $M_w$ is determined by means of GPC (= gel permeation chromatography) against an internal polystyrene standard.

In some embodiments of the present invention, the glass transition temperature (Tg) of the transparent polymer is 70 °C or more and 250 °C or less.

Tg is measured based on changes in the heat capacity observed in Differential scanning colorimetry like described in http://pslc.ws/macrog/dsc.htm; Rickey J Seyler, Assignment of the Glass Transition, ASTM publication code number (PCN) 04-012490-50.

For example, as the transparent polymer for the transparent matrix material, poly(meth)acrylates, epoxys, polyurethanes, polysiloxanes, can be used preferably.

In a preferred embodiment of the present invention, the weight average molecular weight (Mw) of the polymer as the transparent matrix material is in the range from 1,000 to 300,000 g/mol, more preferably it is from 10,000 to 250,000 g/mol.

According to the present invention, publicly known anti-oxidants, radical quenchers, photo initiators and/or surfactants can be used preferably like described in WO 2016/134820A.

- Light emitting moiety (110)

In a preferable embodiment of the present invention, said light emitting moiety (110) is an organic and/or inorganic light emitting material, preferably it is an organic dye, inorganic phosphor and/or a semiconducting light emitting nanoparticle such as a quantum material.

In some embodiments of the present invention, the total amount of the light emitting moiety (110) is in the range from 0.1wt.% to 90wt.% based on the total amount of the $1^{st}$ pixel (161), preferably from 10wt.% to 70wt.%, more preferably from 30wt.% to 50wt.%.

- iii) Semiconducting light emitting nanoparticle

According to the present invention, the term "semiconductor" means a material that has electrical conductivity to a degree between that of a conductor (such as copper) and that of an insulator (such as glass) at room temperature. Preferably, a semiconductor is a material whose electrical conductivity increases with the temperature.

The term "nanosized" means the size in between 0.1 nm to 150 nm, more preferably 3nm to 50 nm.

Thus, according to the present invention, "semiconducting light emitting nanoparticle" is taken to mean that the light emitting material which size is in between 0.1nm to 150 nm, more preferably 3nm to 50nm, having electrical conductivity to a degree between that of a conductor (such as copper) and that of an insulator (such as glass) at room temperature, preferably, a semiconductor is a material whose electrical conductivity increases with the temperature, and the size is in between 0.1 nm and 150 nm, preferably 0,5 nm to 150 nm, more preferably 1 nm to 50 nm.

According to the present invention, the term "size" means the average diameter of the longest axis of the semiconducting nanosized light emitting particles.

The average diameter of the semiconducting nanosized light emitting particles is calculated based on 100 semiconducting light emitting nanoparticles in a TEM image created by a Tecnai G2 Spirit Twin T-12 Transmission Electron Microscope.

In a preferred embodiment of the present invention, the semiconducting light emitting nanoparticle of the present invention is a quantum sized material.

According to the present invention, the term "quantum sized" means the size of the semiconducting material itself without ligands or another surface modification, which can show the quantum confinement effect, like described in, for example, ISBN:978-3-662-44822-9.

For example, CdS, CdSe, CdTe, ZnS, ZnSe, ZnSeS, ZnTe, ZnO, GaAs, GaP, GaSb, HgS, HgSe, HgSe, HgTe, InAs, InP, InPZn, InPZnS, InPZnSe, InPZnSeS, InPZnGa, InPGaS, InPGaSe, InPGaSeS, InPZnGaSeS and InPGa, InCdP, InPCdS, InPCdSe, InSb, AlAs, AlP, AlSb, $Cu_2S$, $Cu_2Se$, CuInS2, $CuInSe_2$, $Cu_2(ZnSn)S_4$, $Cu_2(InGa)S_4$, $TiO_2$ alloys and a combination of any of these can be used.

In a preferred embodiment of the present invention, the $1^{st}$ semiconducting material comprises at least one element of the group 13 of the periodic table, and one element of the group 15 of the periodic table, preferably the element of the group 13 is In, and the element of the group 15 is P, more preferably the $1^{st}$ semiconducting material is selected from the group consisting of InP, InPZn, InPZnS, InPZnSe, InPZnSeS, InPZnGa, InPGaS, InPGaSe, InPGaSeS, InPZnGaSeS and InPGa.

According to the present invention, a type of shape of the core of the semiconducting light emitting nanoparticle, and shape of the semiconducting light emitting nanoparticle to be synthesized are not particularly limited.

For examples, spherical shaped, elongated shaped, star shaped, polyhedron shaped, pyramidal shaped, tetrapod shaped, tetrahedron shaped, platelet shaped, cone shaped, and irregular shaped core and - or a semiconducting light emitting nanoparticle can be synthesized.

In some embodiments of the present invention, the average diameter of the core is in the range from 1.5 nm to 3.5 nm.

The average diameter of the core is calculated based on 100 semiconducting light emitting nanoparticles in a TEM image created by a Tecnai G2 Spirit Twin T-12 Transmission Electron Microscope.

In some embodiments of the present invention, at least one the shell layer comprises or a consisting of a $1^{st}$ element of group 12 of the periodic table and a $2^{nd}$ element of group 16 of the periodic table, preferably, the $1^{st}$ element is Zn, and the $2^{nd}$ element is S, Se, or Te; preferably a first shell layer covering directly onto said core comprises or a consisting of a $1^{st}$ element of group 12 of the periodic table and a $2^{nd}$ element of group 16 of the periodic table, preferably, the $1^{st}$ element is Zn, and the $2^{nd}$ element is S, Se, or Te.

In a preferred embodiment of the present invention, at least one shell layer (a first shell layer) is represented by following formula (XI), preferably the shell layer directly covering the core is represented by the chemical formula (XI);

$ZnS_xSe_yTe_z$ - (XI)

wherein 0≤x≤1, 0≤y≤1, 0≤z≤1, and x+y+z=1, preferably 0≤x≤1, 0≤y≤1, z=0, and x+y=1, preferably, the shell layer is ZnSe, $ZnS_xSe_y$, $ZnSe_yTe_z$ or $ZnS_xTe_z$.

In some embodiments of the present invention, said shell layer is an alloyed shell layer or a graded shell layer, preferably said graded shell layer is $ZnS_xSe_y$, $ZnSe_yTe_z$, or $ZnS_xTe_z$, more preferably it is $ZnS_xSe_y$.

In some embodiments of the present invention, the semiconducting light emitting nanoparticle further comprises 2nd shell layer onto said shell layer, preferably the 2nd shell layer comprises or a consisting of a 3rd element of group 12 of the periodic table and a 4th element of group 16 of the periodic table, more preferably the 3rd element is Zn, and the 4th element is S, Se, or Te with the proviso that the 4th element and the 2nd element are not same.

In a preferred embodiment of the present invention, the 2nd shell layer is represented by following formula (XI'),

$ZnS_xSe_yTe_z$ - (XI')

wherein 0≤x≤1, 0≤y≤1, 0≤z≤1, and x+y+z=1, preferably, the shell layer is ZnSe, $ZnS_xSe_y$, $ZnSe_yTe_z$, or $ZnS_xTe_z$ with the proviso that the shell layer and the 2nd shell layer is not the same.

In some embodiments of the present invention, said 2nd shell layer can be an alloyed shell layer.

In some embodiments of the present invention, the semiconducting light emitting nanoparticle can further comprise one or more additional shell layers onto the 2nd shell layer as a multishell.

According to the present invention, the term "multishell" stands for the stacked shell layers consisting of three or more shell layers.

For example, CdSe/CdS, CdSeS/CdZnS, CdSeS/CdS/ZnS, ZnSe/CdS, CdSe/ZnS, InP/ZnS, InP/ZnSe, InP/ZnSe/ZnS, InZnP /ZnS, InZnP /ZnSe, InZnP /ZnSe/ZnS, InGaP/ZnS, InGaP/ZnSe, InGaP/ZnSe/ZnS, InZnPS/ ZnS, InZnPS ZnSe, InZnPS /ZnSe/ZnS, ZnSe/CdS, ZnSe/ZnS or combination of any of these, can be used. Preferably, InP/ZnS, InP/ZnSe, InP/ZnSe/ZnS, InZnP /ZnS, InZnP /ZnSe, InZnP /ZnSe/ZnS, InGaP/ZnS, InGaP/ZnSe, InGaP/ZnSe/ZnS.

Such semiconducting light emitting nanoparticles are publicly available (for example from Sigma Aldrich) and / or can be synthesized with the method described for example in US 7,588,828 B, US 8,679,543 B and Chem. Mater. 2015, 27, pp 4893-4898.

In some embodiments of the present invention, the composition comprises two or more semiconducting light emitting nanoparticles.

In some embodiments of the present invention, the composition comprises a plurality of semiconducting light emitting nanoparticles.

In some embodiments of the present invention, the total amount of the semiconducting light emitting nanoparticles is in the range from 0.1wt.% to 90wt.% based on the total amount of the composition, preferably from 10wt.% to 70wt.%, more preferably from 30wt.% to 50wt.%.

- Ligands

In some embodiments of the present invention, optionally, the semiconducting light emitting nanoparticle can be directly over coated by one or more ligands, or the outer most surface of the inorganic part of the semiconducting light emitting nanoparticle can be directly coated by the ligands. As an option, ligand coated semiconducting light emitting nanoparticle can be overcoated by a polymer forming a polymer beads having said semiconducting light emitting nanoparticle(s) inside.

As the ligands, phosphines and phosphine oxides such as Trioctylphosphine oxide (TOPO), Trioctylphosphine (TOP), and Tributylphosphine (TBP); phosphonic acids such as Dodecylphosphonic acid (DDPA), Tridecylphosphonic acid (TDPA), Octadecylphosphonic acid (ODPA), and Hexylphosphonic acid (HPA); amines such as Oleylamine, Dedecyl amine (DDA), Tetradecyl amine (TDA), Hexadecyl amine (HDA), and Octadecyl amine (ODA), Oleylamine (OLA), 1-Octadecene (ODE), thiols such as hexadecane thiol and hexane thiol; mercapto carboxylic acids such as mercapto propionic acid and mercaptoundecanoicacid; carboxylic acids such as oleic acid, stearic acid, myristic acid; acetic acid, Polyethylenimine (PEI), monofunctional PEG thiol (mPEG-thiol) or a derivatives of mPEG thiol and a combination of any of these can be used .

Examples of such ligands have been described in, for example, the laid-open international patent application No. WO 2012/059931A.

-Use of the composition

In another aspect, the present invention relates to use of the composition of the present invention, in an electronic device, optical device, sensing device or in a biomedical device or for fabricating an electronic device, sensing device, optical device or a biomedical device.

- A layer containing the composition and a process of fabricating the layer In another aspect, the present invention relates to a layer containing the composition of the present invention.

In another aspect, the present invention relates to a layer containing at least, essentially consisting of or consisting of;

I) a (meth)acrylate polymer, preferably it is obtained or obtainable from the (meth)acrylate monomers in the composition of the present invention;
II) a light emitting moiety; and
III) a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group.

In another aspect, the present invention relates to a process of fabricating the layer of the present invention, wherein the process comprises at least, essentially consisting of or consisting of the following steps;

I) providing a composition of the present invention onto a substrate, preferably
II) curing the composition, preferably said curing is performed by photo irradiation and/or thermal treatment.

In another aspect, the present invention relates to a layer obtained or obtainable from the process.

- Color conversion device (100)

A color conversion device (100) comprising at least a 1$^{st}$ pixel (161) partly or fully filled with the layer of any one of claims 20 to 22 and 24 comprising at least a matrix material (120) containing a light emitting moiety (110), and a bank (150) comprising at least a polymer material, preferably the color conversion device (100) further contains a supporting medium (170).

- 1$^{st}$ pixel (161)

According to the present invention, said 1$^{st}$ pixel (161) comprises at least a matrix material (120) containing a light emitting moiety (110). In a preferable embodiment, the1$^{st}$ pixel (161) is a solid layer obtained or obtainable by curing the composition of the present invention containing at least one acrylate monomer together with at least one light emitting moiety (110), preferably said curing is a photo curing by photo irradiation, thermal curing or a combination of a photo curing and a thermal curing.

In some embodiments of the present invention, the layer thickness of the pixel (161) is in the range from 0.1 to 100$\mu$m, preferably it is from 1 to 50$\mu$m, more preferably from 5 to 25$\mu$m.

In some embodiments of the present invention, the color conversion device (100) further contains a 2$^{nd}$ pixel (162), preferably the device (100) contains at least said 1$^{st}$ pixel (161), 2$^{nd}$ pixel (162) and a 3$^{rd}$ pixel (163), more preferably said 1$^{st}$ pixel (161) is a red color pixel, the 2$^{nd}$ pixel (162) is a green color pixel and the 3$^{rd}$ pixel (163) is a blue color pixel, even more preferably the 1$^{st}$ pixel (161) contains a red light emitting moiety (110R), the 2$^{nd}$ color pixel (162) contains a green light emitting moiety (110G) and the 3$^{rd}$ pixel (163) does not contain any light emitting moiety.

In some embodiments, at least one pixel (160) additionally comprises at least one light scattering particle (130) in the matrix material (120), preferably the pixel (160) contains a plurality of light scattering particles (130).

In some embodiments of the present invention, said 1$^{st}$ pixel (161) consists of one pixel or two or more sub-pixels configured to emit red-color when irradiated by an excitation light, more preferably said sub-pixels contains the same light emitting moiety (110).

- Matrix material (120)

In a preferable embodiment, the matrix material (120) contains a (meth)acrylate polymer, preferably it is a methacrylate polymer, an acrylate polymer or a combination of thereof, more preferably it is an acrylate polymer, even more preferably said matrix material (120) is obtained or obtainable from the composition of the present invention containing at least one acrylate monomer, further more preferably said matrix material (120) is obtained or obtainable from the composition of the present invention containing at least one di-acrylate monomer, particularly preferably said matrix material (120) is obtained or obtainable from the composition of the present invention containing at least one di-acrylate monomer and a monoacrylate monomer, preferably said composition is a photosensitive composition.

- Bank (150)

In some embodiments of the present invention, the height of the bank (150) is in the range from 0.1 to 100μm, preferably it is from 1 to 50μm, more preferably from 1 to 25μm, furthermore preferably from 5 to 20μm.

In a preferred embodiment of the present invention, the bank (150) is configured to determine the area of said 1$^{st}$ pixel (161) and at least a part of the bank (150) is directly contacting to at least a part of the 1$^{st}$ pixel (161), preferably said 2$^{nd}$ polymer of the bank (150) is directly contacting to at least a part of the 1$^{st}$ polymer of the 1$^{st}$ pixel (161).

More preferably, said bank (150) is photolithographically patterned and said 1$^{st}$ pixel (161) is surrounded by the bank (150), preferably said 1$^{st}$ pixel (161), the 2$^{nd}$ pixel (162) and the 3$^{rd}$ pixel (163) are all surrounded by the photolithographically patterned bank (150).

- Polymer material of the bank

In a preferred embodiment of the present invention, said polymer material of the bank is a thermosetting resin, preferably it is a photosensitive resin, more preferably it is a thermosetting and photosensitive resin containing an alkaline soluble polymer, preferably the weight-average molecular weight of said alkaline soluble polymer is in the range from 1,000 to 100,000, more preferably it is from 1,200 to 80,000, preferably the solid-acid value of the alkaline soluble polymer is in the range from 10 to 500mg KOH/g, more preferably it is from 20 to 300mg KOH/g, preferably said alkaline soluble polymer is selected from (meth)acrylate polymer, siloxane (meth)acrylate polymer, more preferably it is a methacrylate polymer, an acrylate polymer or a combination of thereof, even more preferably the polymer material is an acrylate polymer, further more preferably said bank (150) is obtained or obtainable from a bank composition containing at least one alkaline soluble polymer and a chemical compound containing at least two (meth)acryloyloxy groups, particularly preferably said bank (150) is obtained or obtainable from a bank composition containing at least one alkaline soluble polymer and a chemical compound containing at least two (meth)acryloyloxy groups and a surfactant, preferably said composition is a photosensitive composition, preferably said bank is a cured layer obtained or obtainable from the composition, more preferably said bank is a photolithographically patterned cured layer obtained or obtainable from the composition.

-Surfactant of the bank

According to the present invention, preferably said bank (150) further contains a surfactant, preferably at least a part of the surface of the bank is covered by said surfactant, more preferably the surface of the bank is hydrophobic, even more preferably the surface of the top part of the bank is oil-repellent, preferably the total amount of the surfactant is in the range from 0.001 to 5wt.%, more preferably from 0.01 to 4wt.%, even more preferably from 0.05 to 3wt.%, furthermore preferably from 0.1 to 1wt.% based on the total amount of the bank.

In a further preferable embodiment, the bank (150) contains a nonionic surfactant, preferably said nonionic surfactant is a hydrocarbon based nonionic surfactant, fluorine-based nonionic surfactant, organosilicon based nonionic surfactant or a combination of these, more preferably said hydrocarbon based nonionic surfactant is selected from one or more members the group consisting of polyoxyethylene alkyl ethers, such as polyoxyethylene lauryl ether, polyoxyethylene oleyl ether and polyoxyethylene cetyl ether; polyoxyethylene fatty acid diester; polyoxyethylene fatty acid monoester; polyoxyethylene polyoxypropylene block polymer; acetylene alcohol; acetylene glycol such as 3-methyl-1-butyne-3-ol, 3-methyl-1-pentyn-3-ol, 3,6-dimethyl-4-octyne-3,6-diol, 2,4,7,9-tetramethyl-5-decyne-4,7-diol, 3,5-dimethyl-1- hexyne-3-ol, 2,5-di-methyl-3-hexyne-2,5-diol, 2,5-di- methyl-2,5-hexanediol; polyethoxylate of acetylene alcohol; acetylene glycol derivatives, such as polyethoxylate of acetylene glycol; preferably fluorine-based nonionic surfactant is selected from one or more of fluorine-containing surfactants; preferably said hydrocarbon based nonionic surfactant is selected from organosiloxane surfactants, preferably the surfactant is a fluorine-based nonionic surfactant.

- Saccharide in the bank

In a preferred embodiment of the present invention, the bank (150) further contains a saccharide, preferably said saccharide is selected from a monosaccharide, an oligosaccharide, a polysaccharide or a mixture of thereof, more preferably it is an oligosaccharide, even more preferably said saccharide is an oligosaccharide formed by dehydrating and condensing 2 to 10 molecules of a monosaccharide, and also includes a cyclic oligosaccharide (for example, cyclodextrin), furthermore preferably it is cyclodextrin or disaccharide obtained by condensing two molecules of monosaccharide, even more prerably it is a disaccharide obtained by condensing two molecules of monosaccharide, furthermore prerferably the saccharide is oligosaccharide having an alkylene oxide having 1 to 6 carbon atoms, more preferably it has an alkylene oxide having 2 to 5 carbon atoms, and further preferably it has an ethylene oxide or propylene oxide, particulary preferably it is sucrose-alkyleneoxide-lauricacid ester, preferably the total amount of the surfactant is in the range from 0.001 to 1wt.%, more preferably from 0.1 to 60wt.%, even more preferably from 1 to 40wt.%, furthermore preferably from 10 to 30wt.% based on the total solid contents of the polymer material. For examples, sucrose ethylene oxide adduct can be used preferably.

-Colorant in the bank

In a preferable embodiment of the present invention, the bank (150) further comprises a colorant, preferably said colorant is an organic colorant and/or an inorganic colorant, more preferably it is a black colorant selected from an organic black pigment and/or inorganic black pigment, preferably said black colorant has a light transmittance ratio represented by [light transmittance at the wavelength of 365 nm] / [light transmittance at the wavelength of 500 nm] of 1.2 or more, more preferably the ratio is 2.0 or more, preferably said black colorant has a light transmittance ratio represented by [light transmittance at the wavelength of 365 nm] / [light transmittance at the wavelength of 500 nm] of 5.0 or less, even more preferably it is in the range from 1.2 to 5.0, further more preferably it is from 2.0 to 4.0 provided that the transmittance is obtained by measuring a film obtained by the following steps: applying a compoisiton in which 10 mass % of a black colorant is dispersed based on the total amount of the resin forming a film having a film thickness of 10 $\mu$m by applying said composition to a glass substrate, and curing at 100°C, then the obtained film is measured using UV-vis-NIR (Hitachi High-Technologies Corporation), preferably said inorganic black pigment is zirconium nitride, preferably said organic black pigment is a mixture of two or more organic color pigments, more preferably it is a mixture of red, green blue organic color pigments configured to show black color by mixing, further more preferably said organic black pigment is a mixture selected from the group consisting of an azo type, a phthalocyanine type, a quinacridone type, a benzimidazolone type, an isoindolinone type, a dioxazine type, an indanthrene type and a perylene type organic pigments, particulary preferably said organic black pigment is a mixture of one selected from the group consisting of C. I. Pigment Orange 43, C. I. Pigment Orange 64 and C. I. Pigment Orange 72, with C. I. Pigment Blue 60, C. I. Pigment Green 7, C. I. Pigment Green 36 and C. I. Pigment Green 58.

Preferably, the total amount of said colorant is 3 to 80wt.%, preferably 5 to 50wt.% based on the total amount of the polymer material of the bank.

- Supporting medium (170)

In some embodiments of the present invention, said supporting medium (170) is a substrate, more preferably it is a transparent substrate.

In general, said substrate such as a transparent substrate can be flexible, semi-rigid or rigid.

Publicly known transparent substrate suitable for optical devices can be used as desired.

Preferably, as a transparent substrate, a transparent polymer substrate, glass substrate, thin glass substrate stacked on a transparent polymer film, transparent metal oxides (for example, oxide silicone, oxide aluminum, oxide titanium), polymer film substrate with transparent metal oxides, can be used. Even more preferably it is a transparent polymer substrate or a glass substrate.

A transparent polymer substrate can be made from polyethylene, ethylene-vinyl acetate copolymer, ethylene-vinyl alcohol copolymer, polypropylene, polystyrene, polymethyl methacrylate, polyvinylchloride, polyvinyl alcohol, polyvinylvutyral, nylon, polyether ether ketone, polysulfone, polyether sulfone, tetrafluoroethylene-erfluoroalkylvinyl ether copolymer, polyvinyl fluoride, tetraflyoroethylene ethylene copolymer, tetrafluoroethylene hexafluoro polymer copolymer, or a combination of any of these.

The term "transparent" means at least around 60 % of incident light transmittal at the thickness used in a photovoltaic device and at a wavelength or a range of wavelength used during operation of photovoltaic cells. Preferably, it is over 70 %, more preferably, over 75%, the most preferably, it is over 80 %.

- Bank composition

the bank (150) is obtained or obtainable from, or a cured layer of the bank composition comprises at least

(I) an alkaline soluble polymer,
(II) a polymerization initiator, and
(III) a chemical compound containing at least two (meth)acryloyloxy groups, preferably said composition is a photosensitive composition, preferably said at least two(meth)acryloyloxy groups are two or more acryloyloxy groups, methacryloyloxy groups or a combinaiton of these, preferably the total amount of the chemical compound containing said at least two (meth)acryloyloxy groups based on the total amount of the alkaline soluble polymer is in the range from 5wt.% to 1,000wt.%, more preferably from 10wt.% to 500wt.%, even more preferably it is from 15wt.% to 300wt.% from the viewpoint of compatibility with resin., preferably said chemical compound is a monomer having the molecular weight 2000 or less, more preferably in the range from 2000 to 50, even more preferably from 1000 to 100. Preferably it is relatively smaller than the alkali-soluble polymer from the viewpoint of reactivity.

Here, the term "(meth)acryloyloxy group" is a general term for the acryloyloxy group and the methacryloyloxy group. This compound is a compound that can form a crosslinked structure by reacting with the alkali-soluble polymer . Here, in order to form a crosslinked structure, a compound containing two or more acryloyloxy groups or methacryloyloxy groups, which are reactive groups, is needed, and in order to form a higher- order crosslinked structure, it preferably contains three or more acryloyloxy groups or methacryloyloxy groups.
Further, the (meth)acryloyloxy group-containing compounds can be used alone or in combination of two or more.
Preferably said chemical compound containing at least two (meth)acryloyloxy groups, is a poly acrylate monomer having at least three (meth)acryloyloxy groups, more preferably it is a poly acrylate monomer selected from one or more member of the group consisting of a poly acrylate monomer having three (meth)acryloyloxy groups, a poly acrylate monomer having four (meth)acryloyloxy groups, a poly acrylate monomer having five (meth)acryloyloxy groups, a poly acrylate monomer having six (meth)acryloyloxy groups, even more preferably it is a poly acrylate monomer having five (meth)acryloyloxy groups, a poly acrylate monomer having six (meth)acryloyloxy groups or a mixture of thereof,

preferably said poly acrylate monomer having three (meth)acryloyloxy groups is selected from one or more member of the group consisting of trimethylolpropane triacrylate, trimethylolpropaneethoxy triacrylate, trimethylolpropanepropoxy triacrylate, glycerinpropoxy triacrylate, pentaerythritol triacrylates;

preferably said poly acrylate monomer having four (meth)acryloyloxy groups is selected from one or more member of the group consisting of pentaerythritol tetraacrylates, ditrimethylolpropane tetraacrylate, pentaerythritolehoxy tetraacrylates;

preferably said poly acrylate monomer having five (meth)acryloyloxy groups is dipentaerythritol hexaacrylates, preferably said poly acrylate monomer having six (meth)acryloyloxy groups is dipentaerythritol pentaacrylate, the most preferably said chemical compound is dipentaerythritol hexaacrylates, dipentaerythritol pentaacrylate or a mixture of thereof.

- Alkali-soluble polymer

The composition according to the present invention comprises an alkali-soluble polymer .
The alkali-soluble polymer used in the present invention preferably comprises an acryloyl group. Further, the alkali-soluble polymer used in the present invention is not particularly limited and is preferably selected from a polysiloxane containing a siloxane bond in its main skeleton, and a (meth)acrylate polymer. Among them, it is more preferable to use a methacrylate polymer, an acrylate polymer or a combination of thereof, even more preferably it is an acrylate polymer
The alkali-soluble polymer used in the present invention can have a carboxyl group. By having a carboxyl group, the solubility of the alkali-soluble polymer in a low-concentration developer can be improved.
According to the present invention, the term "Alkali-soluble polymer" means a polymer soluble in 2.38% **TMAH** aqueous solution at 23.0 ± 0.1°C.

- (meth)acrylate polymer for bank composition

Here, the term "(meth)acrylate" is a general term for an acrylate and a methacrylate.
According to the present invention, when a low-concentration developer is used and/or low curing temperature is applied, it is preferable to use one or more of (meth)acrylate polymers.

The alkali-soluble polymer used in the present invention can be selected from generally used methacrylate polymer, an acrylate polymer or a combination of thereof, more preferably it is an acrylic polymer, for example, polyacrylic acid, polymethacrylic acid, polyalkyl acrylate, polyalkyl methacrylate, and the like. The acrylic polymer used in the present invention preferably comprises a repeating unit containing an acryloyl group, and also preferably further comprises a repeating unit containing a carboxyl group and/or a repeating unit containing an alkoxysilyl group.

Although the repeating unit containing a carboxyl group is not particularly limited as long as it is a repeating unit containing a carboxyl group at its side chain, a repeating unit derived from an unsaturated carboxylic acid, an unsaturated carboxylic anhydride or a mixture thereof is preferable.

Although the repeating unit containing an alkoxysilyl group can be a repeating unit containing an alkoxysilyl group at its side chain, it is preferably a repeating unit derived from a monomer represented by the following formula (B):

$$X^B\text{-}(CH_2)_a\text{-}Si(OR^B)_b(CH_3)_{3-b} \qquad \text{(B)}$$

wherein,

$X^B$ is a vinyl group, a styryl group or a (meth)acryloyloxy group, $R^B$ is a methyl group or an ethyl group, a is an integer of 0 to 3, and b is an integer of 1 to 3.

Further, it is preferable that the above-described polymer contains a repeating unit containing a hydroxyl group, which is derived from a hydroxyl group-containing unsaturated monomer.

The mass average molecular weight of the alkali-soluble polymer according to the present invention is not particularly limited, and preferably it is in the range from 1,000 to 100,000, more preferably it is from 1,200 to 80,000, even more preferably 1,000 to 40,000, furthermore preferably 2,000 to 30,000. Here, the mass average molecular weight is a mass average molecular weight in terms of polystyrene according to gel permeation chromatography. In addition, as far as the number of acid groups is concerned, preferably the solid-acid value of the alkaline soluble polymer is in the range from 10 to 500mg KOH/g, more preferably it is from 20 to 300mg KOH/g, even more preferably from 40 to 190 mgKOH/g, furthermore preferably 60 to 150 mgKOH/g, from the viewpoint of enabling development with a low-concentration alkaline developer and achieving both reactivity and storage stability. For examples, 2-Propenoic acid, 2-methyl-, polymer with 2-hydroxyethyl 2-methyl-2-propenoate, 2-isocyanatoethyl 2-propenoate and methyl 2-methyl-2-propenoate (C6 H10 O3 . C6 H7 N O3 . C5 H8 O2 . C4 H6 O2)x (CAS Registry Number 1615232-03-05) can be used preferably.

- Polysiloxane

The alkali-soluble polymer preferably contains a siloxane (Si-O-Si) bond as its main skeleton. In the present invention, polymer containing a siloxane bond as its main skeleton is referred to as polysiloxane. Depending on the number of the oxygen atoms bonded to a silicon atom, the skeleton structure of polysiloxane can be classified as follows: a silicone skeleton (the number of oxygen atoms bonded to a silicon atom is 2), a silsesquioxane skeleton (the number of oxygen atoms bonded to a silicon atom is 3), and a silica skeleton (the number of oxygen atoms bonded to a silicon atom is 4). In the present invention, any of these can be used. The polysiloxane molecule can contain a combination of a plurality of these skeletal structures. Preferably, polysiloxane used in the present invention contains a silsesquioxane skeleton.

Polysiloxane generally has a silanol group or an alkoxysilyl group. Such silanol group and alkoxysilyl group mean a hydroxyl group and alkoxy group directly bonded to a silicon that forms a siloxane skeleton. Here, the silanol group and alkoxysilyl group are considered to contribute to the reaction with the silicon-containing compound described below, in addition to the action of accelerating the curing reaction when forming a cured film using the composition. For this reason, it is preferable that polysiloxane has these groups.

As such a (meth)acrylate polymer and/or a polysiloxane, publicly available polymer like described in WO2021/018927 A1 can be used preferably.

In some embodiments, a mixture of the polysiloxane and acrylic polymer can be used as the alkali-soluble polymer.

Further, a cured film is formed through application of the composition according to the present invention onto a substrate, image wise exposure, and development. At this time, it is necessary that a difference in solubility occurs between the exposed area and the unexposed area, and the coating film in the unexposed area should have a certain or more solubility in a developer. For example, it is considered that a pattern can be formed by exposure and development if dissolution rate of the coating film after prebaked, in a 2.38% tetramethylammonium hydroxide (hereinafter sometimes referred to as TMAH) aqueous solution (hereinafter sometimes referred to as alkali dissolution rate or ADR, which is described later in detail) is 50 Å/sec or more. However, since the required solubility varies depending on the film thickness of the cured film to be formed and the development conditions, the alkali-soluble polymer should be appropriately selected according to the development conditions. Although it varies depending on the type and addition amount of the photosensitizer or the silanol catalyst contained in the composition, for example, if the film thickness is 0.1 to 100 μm (1,000 to 1,000,000 Å), the dissolution rate in a 2.38% TMAH aqueous solution is preferably 50 to 20,000 Å/sec, and more preferably

100 to 10,000 Å/sec.

[Measurement of alkaline dissolution rate (ADR) and calculation method thereof]

Using a TMAH aqueous solution as an alkaline solution, the alkali dissolution rate of the alkali-soluble polymer is measured and calculated as described below.

The alkali-soluble polymer is diluted with propylene glycol monomethyl ether acetate (hereinafter referred to as PGMEA) so as to be 35 mass % and dissolved while stirring at room temperature with a stirrer for 1 hour. In a clean room under an atmosphere of temperature of 23.0 ± 0.5°C and humidity of 50 ± 5.0%, using a pipette, 1cc of the prepared alkali-soluble polymer solution is dropped on the center area of a 4-inch silicon wafer having a thickness of 525 μm and spin-coated to make a film having a thickness of 2 ± 0.1 μm, and then the film is heated on a hot plate at 100°C for 90 seconds to remove the solvent. The film thickness of the coating film is measured with a spectroscopic ellipsometer (manufactured by J.A. Woollam).

Next, the silicon wafer having this film is gently immersed in a glass petri dish having a diameter of 6 inches, into which 100 ml of a TMAH aqueous solution adjusted to 23.0 ± 0.1°C and having a predetermined concentration was put, then allowed to stand, and the time until the coating film disappears is measured. The dissolution rate is determined by dividing by the time until the film in the area of 10 mm inside from the wafer edge disappears.

In the case that the dissolution rate is remarkably slow, the wafer is immersed in a TMAH aqueous solution for a certain period and then heated for 5 minutes on a hot plate at 200°C to remove moisture taken in the film during the dissolution rate measurement. Thereafter, film thickness is measured, and the dissolution rate is calculated by dividing the amount of change in film thickness before and after the immersion, by the immersion time. The above measurement method is performed 5 times, and the average of the obtained values is taken as the dissolution rate of the alkali-soluble polymer .

-Polymerization initiator

The composition according to the present invention comprises a polymerization initiator. The polymerization initiator includes a polymerization initiator that generates an acid, a base or a radical by radiation, and a polymerization initiator that generates an acid, a base or a radical by heat. In the present invention, the former is preferable and the photo radical generator is more preferable, in terms of process shortening and cost since the reaction is initiated immediately after the radiation irradiation and the reheating process performed after the radiation irradiation and before the developing process can be omitted.

The photo radical generator can improve the resolution by strengthening the pattern shape or increasing the contrast of development. The photo radical generator used in the present invention is a photo radical generator that emits a radical when irradiated with radiation. Here, examples of the radiation include visible light, ultraviolet light, infrared light, X-ray, electron beam, α-ray, and γ-ray.

The addition amount of the photo radical generator is preferably 0.001 to 50 mass %, more preferably 0.01 to 30 mass %, based on the total mass of the alkali-soluble polymer , though the optimal amount thereof depends on the type and amount of active substance generated by decomposition of the photo radical generator, the required photosensitivity, and the required dissolution contrast between the exposed area and unexposed area. If the addition amount is less than 0.001 mass %, the dissolution contrast between the exposed area and unexposed portion is too low, and the addition effect is not sometimes exhibited. On the other hand, when the addition amount of the photo radical generator is more than 50 mass %, colorless transparency of the coated film sometimes decreases, because it sometimes occurs that cracks are generated in the coated film to be formed and coloring due to decomposition of the photo radical generator becomes remarkable. Further, when the addition amount becomes large, thermal decomposition of the photo radical generator causes deterioration of the electrical insulation of the cured product and release of gas, which sometimes become a problem in subsequent processes. Further, the resistance of the coated film to a photoresist stripper containing monoethanolamine or the like as a main component sometimes deteriorates.

Examples of the photo radical generator include azo-based, peroxide-based, acylphosphine oxide-based, alkylphenone-based, oxime ester-based, and titanocene-based initiators. Among them, alkylphenone-based, acylphosphine oxide-based and oxime ester-based initiators are preferred, and 2,2-dimethoxy-1,2-diphenylethan-1-one, 1-hydroxy- cyclohexylphenyl ketone, 2-hydroxy-2-methyl-1- phenylpropan-1-one, 1-[4-(2-hydroxyethoxy)phenyl]-2- hydroxy-2-methyl-1-propan-1-one, 2-hydroxy-1-{4-[ 4- (2-hydroxy-2-methylpropionyl)-benzyl]phenyl}-2-methylpropan-1-one, 2-methyl-1-(4-methylthiophenyl)-2- morpholinopropan-1-one, 2-benzyl-2-dimethylamino-1- (4-morpholinophenyl)-1-butanone, 2-(dimethylamino)- 2-[(4-methylphenyl)methyl]-1-[4-(4-morpholinyl)-phenyl]-1-butanone, 2,4,6-trimethylbenzoyldiphenyl phosphine oxide, bis (2,4,6-trimethylbenzoyl)-phenyl- phosphine oxide, 1,2-octanedione, 1-[4-(phenylthio)-2-(O-benzoyloxime)], ethanone, 1-[9-ethyl-6-(2- methylbenzoyl)-9H-carbazol-3-yl]-1-(O-acetyloxime), and the like are included.

-Surfactant

Further, the composition according to the present invention can optionally comprise a surfactant. Preferably it is a nonionic surfactant, preferably said nonionic surfactant is a hydrocarbon based nonionic surfactant, fluorine-based nonionic surfactant, such as Fluorad (trade name, 3M Japan Limited), Megafac (trade name, DIC Corporation), Surflon (trade name, AGC Inc.), organosilicon based nonionic surfactant, such as KP341 (trade name, Shin-Etsu Chemical Co., Ltd.) or a combination of these, more preferably said hydrocarbon based nonionic surfactant is selected from one or more members the group consisting of polyoxyethylene alkyl ethers, such as polyoxyethylene lauryl ether, polyoxyethylene oleyl ether and polyoxyethylene cetyl ether; polyoxyethylene fatty acid diester; polyoxyethylene fatty acid monoester; polyoxyethylene polyoxypropylene block polymer; acetylene alcohol; acetylene glycol such as 3-methyl-1-butyne-3-ol, 3-methyl-1-pentyn-3-ol, 3,6-dimethyl-4-octyne-3,6-diol, 2,4,7,9-tetramethyl-5-decyne-4,7-diol, 3,5-dimethyl-1- hexyne-3-ol, 2,5-di-methyl-3-hexyne-2,5-diol, 2,5-di- methyl-2,5-hexanediol; polyethoxylate of acetylene alcohol; acetylene glycol derivatives, such as polyethoxylate of acetylene glycol; preferably fluorine-based nonionic surfactant is selected from one or more of fluorine-containing surfactants; preferably said hydrocarbon based nonionic surfactant is selected from organosiloxane surfactants, preferably the surfactant is a fluorine-based nonionic surfactant. Especially, Megafac RS series (trade name, DIC Corporation) is the most suitable one for the present invention from the view point of realizing improved hydrophobic bank surface, and/or realizing improved oil-repellent bank surface (especially realizing an oil-repellent surface of the top part of a bank after fabrication of it).

Preferably the total amount of the surfactant is in the range from 0.001 to 5wt.%, more preferably from 0.01 to 4wt.%, even more preferably from 0.05 to 3wt.%, furthermore preferably from 0.1 to 1wt.% based on the total amount of the total solid contents of the bank composition (bank composition).

The surfactant is added for the purpose of improving coating properties, developability, realizing improved hydrophobic bank surface, and/or realizing improved oil-repellent bank surface.

-Saccharide

In a preferred embodiment of the present invention, the bank composition further comprises a saccharide, preferably the total amount of the surfactant is in the range from 0.001 to 1wt.%, more preferably from 0.1 to 60wt.%, even more preferably from 1 to 40wt.%, furthermore preferably from 10 to 30wt.% based on the total solid contents of the bank composition.

According to the study of the present inventors, it has been found that such a saccharide has a dissolution promoting effect in a developer. It is considered that saccharide is dissolved in the solvent in the composition and dissolved also in the developer, thus having a dissolution promoting effect, because it has hydrophilicity and hydrophobicity. Such an effect is particularly beneficial when the development of the composition according to the present invention is carried out with a low-concentration developer.

In a preferred embodiment of the present invention, said saccharide is selected from a monosaccharide, an oligosaccharide, a polysaccharide or a mixture of thereof, more preferably it is an oligosaccharide, even more preferably said saccharide is an oligosaccharide formed by dehydrating and condensing 2 to 10 molecules of a monosaccharide, and also includes a cyclic oligosaccharide (for example, cyclodextrin), furthermore preferably it is cyclodextrin or disaccharide obtained by condensing two molecules of monosaccharide, even more prerably it is a disaccharide obtained by condensing two molecules of monosaccharide, furthermore prerferably the saccharide is oligosaccharide having an alkylene oxide having 1 to 6 carbon atoms, more preferably it has an alkylene oxide having 2 to 5 carbon atoms, and further preferably it has an ethylene oxide or propylene oxide, particulary preferably it is sucrose-alkyleneoxide-lauricacid ester.

- Colorant

In a preferred embodiment of the present invention, the bank composition further comprises a colorant, preferably the total amount of said colorant is 3 to 80wt.%, preferably 5 to 50wt.% based on the total amount of the solid contents of the bank composition.

Preferably said colorant is an organic colorant and/or an inorganic colorant, more preferably it is a black colorant selected from an organic black pigment and/or inorganic black pigment, preferably said black colorant has a light transmittance ratio represented by [light transmittance at the wavelength of 365 nm] / [light transmittance at the wavelength of 500 nm] of 1.2 or more, more preferably the ratio is 2.0 or more, preferably said black colorant has a light transmittance ratio represented by [light transmittance at the wavelength of 365 nm] / [light transmittance at the wavelength of 500 nm] of 5.0 or less, even more preferably it is in the range from 1.2 to 5.0, further more preferably it is from 2.0 to 4.0 provided that the transmittance is obtained by measuring a film obtained by the following steps: applying a compoisiton in which 10 mass % of a black colorant is dispersed based on the total amount of the resin forming a film having a film thickness of 10 μm by applying said composition to a glass substrate, and curing at 100°C, then the obtained film is measured using UV-vis-NIR

(Hitachi High-Technologies Corporation), preferably said inorganic black pigment is zirconium nitride, preferably said organic black pigment is a mixture of two or more organic color pigments, more preferably it is a mixture of red, green blue organic color pigments configured to show black color by mixing, further more preferably said organic black pigment is a mixture selected from the group consisting of an azo type, a phthalocyanine type, a quinacridone type, a benzimidazolone type, an isoindolinone type, a dioxazine type, an indanthrene type and a perylene type organic pigments, particulary preferably said organic black pigment is a mixture of one selected from the group consisting of C. I. Pigment Orange 43, C. I. Pigment Orange 64 and C. I. Pigment Orange 72, with C. I. Pigment Blue 60, C. I. Pigment Green 7, C. I. Pigment Green 36 and C. I. Pigment Green 58.

As the colorant used in the present invention (preferably black colorant), either an inorganic pigment or an organic pigment, or a combination of two or more pigments can be used as long as it satisfies the required absorbance.

When an organic type black colorant is used in the bank, it is preferable to combine two or more organic pigments to obtain a black colorant. For examples, by mixing respective colors of red, green and blue organic pigments, a black color colorant can be obtained.

The colorant used in the present invention can be used in combination with a dispersant. As the dispersant, an organic compound-based dispersant such as a polymer dispersant described, for example, in JP-A 2004-292672 can be used.

-Solvent

In a preferred embodiment of the present invention, the bank composition further comprises a solvent.

The type solvent is not particularly limited and publicly available solvents can be used as long as it can uniformly dissolve or disperse the above-described alkali-soluble polymer, the polymerization initiator and a chemical compound containing at least two (meth)acryloyloxy groups.

Preferably said solvent is selected from one or more of the members of the group consisting of ethylene glycol monoalkyl ethers, such as ethylene glycol monomethyl ether, ethylene glycol monoethyl ether, ethylene glycol monopropyl ether and ethylene glycol monobutyl ether; diethylene glycol dialkyl ethers, such as diethylene glycol dimethyl ether, diethylene glycol diethyl ether, diethylene glycol dipropyl ether and diethylene glycol dibutyl ether; ethylene glycol alkyl ether acetates, such as methyl cellosolve acetate and ethyl cellosolve acetate; propylene glycol monoalkyl ethers, such as propylene glycol monomethyl ether and propylene glycol monoethyl ether; propylene glycol alkyl ether acetates such as PGMEA, propylene glycol monoethyl ether acetate and propylene glycol monopropyl ether acetate; aromatic hydrocarbons, such as benzene, toluene and xylene; ketones, such as methyl ethyl ketone, acetone, methyl amyl ketone, methyl isobutyl ketone and cyclohexanone; alcohols, such as ethanol, propanol, butanol, hexanol, cyclohexanol, ethylene glycol and glycerin; esters, such as ethyl lactate, ethyl 3-ethoxypropionate, methyl 3-methoxypropionate; and cyclic esters, such as γ-butyrolactone, more preferably said solvent is a combination of propylene glycol alkyl ether acetates or esters, and cyclic esters, such as γ-butyrolactone, preferably the total amount of said solvent based on the total amount of the composition is in the range from 1wt.% to 99wt.%, preferably from 5wt.% to 90wt.%, even more preferably from 10wt.% to 80wt.%, furthermore preferably from 20wt.% to 70wt.%.

- Other additives

The composition according to the present invention can optionally comprise other additives. As such additives, a developer dissolution accelerator, a scum remover, an adhesion enhancer, a polymerization inhibitor, an antifoaming agent, a surfactant, a photosensitizing enhancing agent, a crosslinking agent, a curing agent can be added.

Thus, according to the present invention, preferably the bank composition further comprises at least one additive selected from one or more members of the group consisting of a developer dissolution accelerator, a scum remover, an adhesion enhancer, a polymerization inhibitor, an antifoaming agent, a surfactant, a photosensitizing enhancing agent, a crosslinking agent, and/or a curing agent.

The developer dissolution accelerator or scum remover has a function of adjusting the solubility of the formed coated film in the developer and preventing scum from remaining on the substrate after development. As such an additive, crown ether can be used. The crown ether having the simplest structure is represented by the general formula $(-CH_2-CH_2-O-)_n$. Preferred in the present invention are those in which n is 4 to 7. When x is set to be the total number of atoms constituting the ring and y is set to be the number of oxygen atoms contained therein, the crown ether is sometimes called x-crown-y-ethers. In the present invention, preferred is selected from the group consisting of crown ethers, wherein x = 12, 15, 18 or 21, and y = x/3, and their benzo condensates and cyclohexyl condensates. Specific examples of more preferred crown ethers include 21-crown-7-ether, 18-crown-6-ether, 15-crown-5-ether, 12-crown-4-ether, dibenzo-21- crown-7-ether, dibenzo-18-crown-6-ether, dibenzo-15- crown-5-ether, dibenzo-12-crown-4-ether, dicyclohexyl- 21-crown-7-ether, dicyclohexyl-18-crown-6-ether, dicyclo-hexyl-15-crown-5-ether, and dicyclohexyl-12-crown-4-ether. In the present invention, among them, most preferred is selected from 18-crown-6-ether and 15-crown-5-ether.

The content thereof is preferably 0.05 to 15 mass %, more preferably 0.1 to 10 mass %, based on the total mass of the alkali-soluble polymer .

The adhesion enhancer has an effect of preventing a pattern from peeling off due to stress applied after baking when a cured film is formed using the composition according to the present invention. As the adhesion enhancer, imidazoles, silane coupling agents, and the like are preferred. Among imidazoles, 2-hydroxybenzimidazole, 2-hydroxyethylbenzimidazole, benzimidazole, 2-hydroxyimidazole, imidazole, 2-mercaptoimidazole and 2-aminoimidazole are preferable, and 2-hydroxybenzimidazole, benzimidazole, 2-hydroxyimidazole and imidazole are particularly preferably used.

As the silane coupling agent, known ones are suitably used, and examples thereof include epoxy silane coupling agents, amino silane coupling agents, mercapto silane coupling agents, and the like. Specifically, 3-glycidoxypropyltrimethoxysilane, 3-glycidoxypropyl- triethoxysilane, N-2-(aminoethyl)-3-aminopropyltri- methoxysilane, N-2-(aminoethyl)-3-aminopropyltri- ethoxysilane, 3-aminopropyltrimethoxysilane, 3-aminopropyltriethoxysilane, 3-ureidopropyltriethoxysilane, 3-chloropropyltriethoxysilane, 3-mercaptopropyltri- methoxysilane, 3-isocyanatopropyltriethoxysilane, and the like are preferred. These can be used alone or in combination of two or more, and the addition amount thereof is preferably 0.05 to 15 mass % based on the total mass of the alkali-soluble polymer.

Further, as the silane coupling agent, a silane compound and siloxane compound having an acid group, or the like can be used. Examples of the acid group include a carboxyl group, an acid anhydride group, a phenolic hydroxyl group, and the like. When it contains a monobasic acid group such as a carboxyl group or a phenolic hydroxyl group, it is preferred that a single silicon-containing compound has a plurality of acid groups.

Exemplified embodiments of such a silane coupling agent include a compound represented by the formula (C):

$$X_nSi(OR^{C3})_{4-n} \qquad (C)$$

or polymer obtained using it as a repeating unit. At this time, a plurality of repeating units having different X or $R^{C3}$ can be used in combination.

**In** the formula, $R^{C3}$ includes a hydrocarbon group, for example, an alkyl group such as a methyl group, an ethyl group, an n-propyl group, an isopropyl group, and an n-butyl group. **In** the general formula (C), a plurality of $R^{C3}$ are included, and each $R^{C3}$ can be identical or different.

As X, those having an acid group such as phosphonium, borate, carboxyl, phenol, peroxide, nitro, cyano, sulfo, and alcohol group are included, and those in which these acid groups are protected by acetyl, aryl, amyl, benzyl, methoxymethyl, mesyl, tolyl, trimethoxysilyl, triethoxysilyl, triisopropylsilyl or trityl group, and an acid anhydride group are included.

Among them, a compound having a methyl group as $R^{C3}$ and a carboxylic acid anhydride group as X, such as an acid anhydride group-containing silicone, is preferable. More specifically, a compound represented by the following formula (X-12-967C (trade name, Shin-Etsu Chemical Co., Ltd.)) or polymer containing a structure corresponding thereto in its terminal or side chain of a silicon-containing polymer such as silicone is preferred.

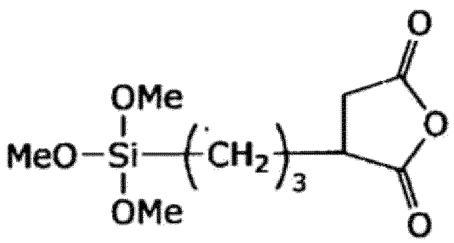

Further, a compound in which thiol, phosphonium, borate, carboxyl, phenol, peroxide, nitro, cyano, and an acid group such as sulfo group is provided at the terminal of dimethyl silicone is also preferable. As such a compound, compounds represented by the following formulae (X-22-2290AS and X-22-1821 (trade name in every case, Shin-Etsu Chemical Co., Ltd.)) are

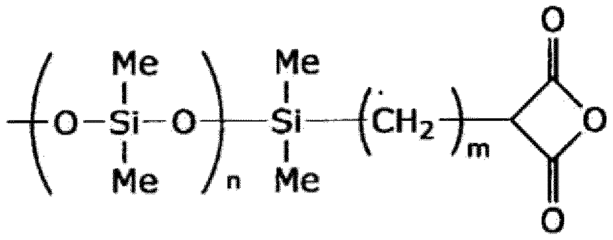

included.

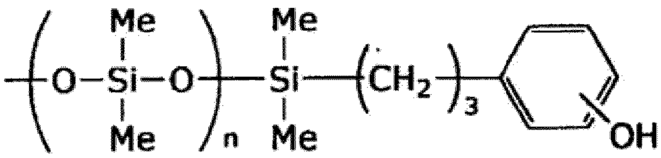

When the silane coupling agent has a silicone structure, if the molecular weight is too large, the compatibility with polysiloxane contained in the composition becomes poor, so that there is a possibility that there is an adverse effect such that the solubility in the developer does not improve, the reactive group remains in the film, and the chemical resistance that can withstand the subsequent process cannot be maintained. For this reason, the mass average molecular weight of the silane coupling agent is preferably 5,000 or less, and more preferably 4,000 or less. The content of the silane coupling agent is preferably 0.01 to 15 mass % based on the total mass of the alkali-soluble polymer .

As the polymerization inhibitor, an ultraviolet absorber as well as nitrone, nitroxide radical, hydroquinone, catechol, phenothiazine, phenoxazine, hindered amine and derivatives thereof can be added. Among them, methylhydroquinone, catechol, 4-t-butylcatechol, 3-methoxycatechol, phenothiazine, chlorpromazine, phenoxazine, **TINUVIN** 144, 292 and 5100 (BASF) as the hindered amine, and TINUVIN 326, 328, 384-2, 400 and 477 (BASF) as the ultraviolet absorber are preferred. These can be used alone or in combination of two or more, and the content thereof is preferably 0.01 to 20 mass % based on the total mass of the alkali-soluble polymer .

As the antifoaming agent, alcohols ($C_{1-18}$), higher fatty acids such as oleic acid and stearic acid, higher fatty acid esters such as glycerin monolaurate, polyethers such as polyethylene glycols (PEG) (Mn: 200 to 10,000) and polypropylene glycols (PPG) (Mn: 200 to 10,000), silicone compounds such as dimethyl silicone oil, alkyl-modified silicone oil and fluoro-silicone oil, and organo-siloxane-based surfactants described in detail below are included. These can be used alone or in combination of a plurality of these, and the content thereof is preferably 0.1 to 3 mass % based on the total mass of the alkali-soluble polymer .

-Photosensitizing enhancing agent

A photosensitizing enhancing agent can be optionally added to the bank composition according to the present invention. The photosensitizing enhancing agent preferably used in the composition according to the present invention includes coumarin, ketocoumarin and their derivatives, thiopyrylium salts, acetophenones, and the like, and specifically, p-bis(o-methylstyryl) benzene, 7-dimethylamino-4- methylquinolone-2,7-amino-4-methylcoumarin, 4,6-di- methyl-7-ethylaminocoumarin, 2-(p-dimethylamino-styryl)-pyridylmethyl-iodide, 7-diethylaminocoumarin, 7-diethylamino-4-methylcoumarin, 2,3,5,6-1H,4H- tetrahydro-8-methyl- quinolizino-<9,9a,1-gh> coumarin, 7-diethylamino-4-trifluoromethylcoumarin, 7-dimethyl-amino-4-trifluoro-methylcoumarin, 7-amino-4-trifluoro- methylcoumarin, 2,3,5,6-1H,4H-tetrahydroquinolizino- <9,9a,1-gh> coumarin, 7-ethylamino-6-methyl-4- trifluoromethylcoumarin, 7-ethylamino-4-trifluoromethylcoumarin, 2,3,5,6-1H,4H-tetrahydro-9-carbo- ethoxyquinolizino-<9,9a,1-gh> coumarin, 3-(2'-N- methylbenzimidazolyl)-7-N,N-diethylaminocoumarin, N-methyl-4-trifluoro-methylpiperidino-<3,2-g> coumarin, 2-(p-dimethylaminostyryl)-benzothiazolylethyl iodide, 3-(2'-benzimidazolyl)-7-N,N-diethylaminocoumarin, 3-(2'-benzothiazolyl)-7-N,N-diethylaminocoumarin, and sensitizing dyes such as pyrylium salts and thiopyrylium salts represented by the following chemical formula. By the addition of the sensitizing dye, patterning using an inexpensive light source such as a high-pressure mercury lamp (360 to 430 nm) becomes possible. The content thereof is preferably 0.05 to 15 mass %, more preferably 0.1 to 10 mass %, based on the total mass of the alkali-soluble polymer .

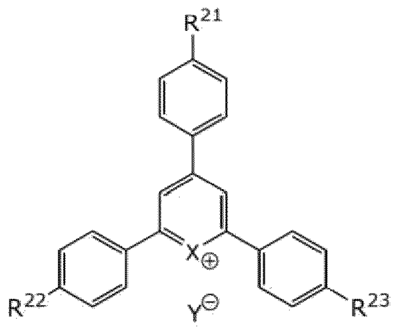

| X | $R^{21}$ | $R^{22}$ | $R^{23}$ | Y |
|---|---|---|---|---|
| S | $OC_4H_9$ | H | H | $BF_4$ |
| S | $OC_4H_9$ | $OCH_3$ | $OCH_3$ | $BF_4$ |
| S | H | $OCH_3$ | $OCH_3$ | $BF_4$ |
| S | $N(CH_3)_2$ | H | H | $ClO_2$ |
| O | $OC_4H_9$ | H | H | $SbF_6$ |

Further, as the photosensitizing enhancing agent, an anthracene skeleton-containing compound can be also used. Specifically, a compound represented by the following formula is included.

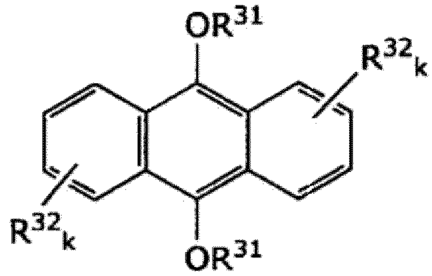

wherein, $R^{31}$ each independently represents a substituent selected from the group consisting of an alkyl group, an aralkyl group, an allyl group, a hydroxyalkyl group, an alkoxyalkyl group, a glycidyl group, and a halogenated alkyl group,

$R^{32}$ each independently represents a substituent selected from the group consisting of a hydrogen atom, an alkyl group, an alkoxy group, a halogen atom, a nitro group, a sulfonic acid group, a hydroxyl group, an amino group, and a carboalkoxy group, and

k is each independently selected from 0 and an integer of 1 to 4.

When such a photosensitizing enhancing agent having an anthracene skeleton is used, its content is preferably 0.01 to 5 mass % based on the total mass of the alkali-soluble polymer .

- Optical device

In another aspect, the invention further relates to an optical device (300, 400, 500) containing at least one color conversion device (100) and a functional medium (320, 420, 520) configured to modulate a light or configured to emit light.

In some embodiments of the present invention, the optical device can be a liquid crystal display device (LCD), Organic Light Emitting Diode (OLED), backlight unit for an optical display, Light Emitting Diode device (LED), Micro Electro Mechanical Systems (here in after "MEMS"), electro wetting display, or an electrophoretic display, a lighting device, and / or a solar cell.

Figures 4 to 6 show some embodiments of the optical device of the present invention.

The term "emission" means the emission of electromagnetic waves by electron transitions in atoms and molecules.

- Process

In another aspect, the invention also relates to a process for fabricating the composition of the present invention comprising at least, essentially consisting or consisting of, the following steps Y1 and Y2, preferably in this sequence or Y3;

Y1) mixing at least one light emitting moiety and a (meth)acrylate monomer to form a 1st composition,
Y2) mixing the 1st composition with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group to form the composition of the present invention; or
Y3) mixing at least one light emitting moiety and a (meth)acrylate monomer with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group to form the composition of the present invention.

**[0242]** - Preferably said (meth)acrylate monomer is represented by the following chemical formula as detailly described in the section of " The composition and (meth)acrylate monomer" above:

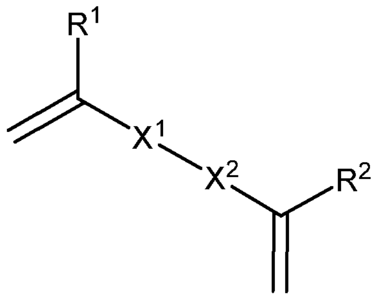

(I).

Preferably said composition comprises a (meth)acrylate monomer represented by following chemical formula (II) as detailly described in the section of " The composition and (meth)acrylate monomer" above;

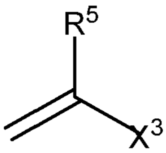

(II)

And said process comprises a following step before step Y1)
Y0) mixing the (meth)acrylate monomer represented chemical formula (I) and the (meth)acrylate monomer represented chemical formula (II).
In a preferable embodiment of the present invention, the method comprises a purification step of the (meth) acrylate monomers. More preferably, said purification step is taken place before step Y1) and/or Y0).
More details of details of the composition such as (meth)acrylate monomers, mixing ratio of the (meth)acrylate monomers, another material, polymer and scattering particles are described in the section of "(meth)acrylate monomer", "polymer" and "scattering particle".
Additional additives as described in the section of "additional material" can be mixed.
In another aspect, the present invention also relates to a method for fabricating a color conversion device (100) of the present invention, containing at least the following steps, preferably in this sequence;

Xi) Providing a bank composition onto a surface of a supporting medium Xii) Curing the bank composition,
Xiii) Applying photo-patterning to the cured said composition to fabricate bank and a patterned pixel region,
Xiv) Providing the composition of the present invention to at least one pixel region, preferably by ink-jetting,
Xv) Curing the composition, preferably said color conversion device (100) further contains a supporting medium (170).

Like described in WO2021/018927 A1, known bank fabrication conditions can be used.
In another aspect, the present invention further relates to a color conversion device (100) obtainable or obtained from the method of the present invention.
In another aspect, the present invention further relates to use of the color conversion device (100) of the present invention in an optical device (300) containing at least one functional medium (320, 420, 520) configured to modulate a light or configured to emit light.
Further, in another aspect, the present invention further relates to an optical device (300) containing at least one functional medium (320, 420, 520) configured to modulate a light or configured to emit light, and the color conversion device (100) of the present invention.

Technical effects of the invention

Present invention provides one or more of the following effects:
Preventing / reducing long term viscosity increase of ink composition, Achiving higher cross-linking density, realizing good compatibility of (meth)acrylate monomers, selecting publically available (meth)acrylate monomers, realizing lower vaper pressure and higher boiling point, achiving a solid film with high polymerization efficiency by QD containing acrylate ink realising an improved solidity of the film derived by (meth)acrylate monomers under short time and week UV curing condition,
**[0255]** Realizing improved optical properties of bank, improved compatibility between a bank and a composition containing a light emitting moiety (e.g. QD ink), improved wetting properties and chemical stability towards a composition containing a light emitting moiety, less degradation of the bank structure upon bringing the composition containing a light emitting moiety into contact with the bank,

realizing adequate chemical resistance of the bank so that no degradation is observed upon filling the wells of the bank structure with QD Ink, realizing low curing temperature (e.g. 100°C) properties of the bank, providing a bank having high resolution and/or excellent light shielding properties. Providing a bank composition configured to be developed even with a low-concentration alkaline developer other than an organic developer and is excellent also in environmental properties,

improved homogeneous dispersion of semiconducting light emitting nanoparticles in the composition, improved homogeneous dispersion of scattering particles in the composition, preferably improved homogeneous dispersion of both semiconducting light emitting nanoparticles and scattering particles, more preferably improved homogeneous dispersion of semiconducting light emitting nanoparticles and/or scattering particles without solvent; composition having lower viscosity suitable for inkjet printing, preferably a composition which can keep lower viscosity even if it is mixed with high loading of semiconducting light emitting nanoparticles and/or scattering particles, even more preferably without solvent; composition having lower vaper pressure for large area uniform printing; improved QY and/or EQE of semiconducting light emitting nanoparticles in the composition, improved QY and/or EQE of semiconducting light emitting nanoparticles after printing; improved thermal stability; easy printing without clogging at a printing nozzle; easy handling of the composition, improved printing properties; simple fabrication process; improved absorbance of blue light; improved solidity of a later made from the composition after inkjet printing.

The working examples 1 - 6 below provide descriptions of the present invention, as well as an in-detail description of their fabrication.

## Working Examples

**Reference Example 1:** Preparation of monomer mixtures

1,6-Hexanediol dimethacrylate (HDDMA) and lauryl acrylate (LA) are stored over molecular sieves 4A. HDDMA is purified by passed through silica gel column prior to use. 4 g of HDDMA and 6 g of LA are mixed in glass vial, thus obtained a monomer mixture. The weight ratio of HDDMA:LA in the monomer mixture is 40:60.
In a same manner as described above, the monomer mixtures of HDDMA:LA (30:70), HDDMA:LA (20:80), NDDA:LA (30:70) are prepared instead of HDDMA:LA (40:60).

**Reference Example 2:** Preparation of QD monomer dispersion

10.41 ml of green Cd-free InP based QD solution in toluene (Merck) and 1.02 g of the monomer mixture obtained in working example 1 are mixed in glass flask. Toluene is evaporated under vacuum at 40 deg.C by rotary evaporator, thus

obtained 3.06 g of QD monomer dispersion.

**Reference Example 3:** Preparation of QD ink

The QD monomer dispersion obtained in reference example 2, the TiO2 monomer dispersion obtained in working example 3, 1.12 g of the monomer mixture obtained in working example 1, 0.051g of photo initiator (Omnirad 819) and 0.041 g of antioxidant (Irganox 1010) are mixed in glass vial. The obtained mixture is agitated by applying ultrasonic and then by magnetic stirring to afford 5g of the QD ink.

**Reference Example 4:** Fabrication of QD test cell for EQE and QY measurement

The QD inks obtained in reference example 3 is injected into a text cell with 15mm gap and photo-cured by irradiating UV light.

**Reference Example 5:** EQE measurement

EQE measurement is carried out by using integrating sphere equipped with excitation light by optical fiber (CWL: 450nm) and spectrometer (C9920, Hamamatsu photonics). To detect the photons of the excitation light, air is used as a reference at room temperature.

The number of photons of light emission from the cell towards the integrating sphere is counted by the spectrometer at room temperature.

EQE is calculated by the following calculation Method.

$$EQE = Photons\ [\textbf{Emission light}] / Photons\ [\textbf{Excitation light}]$$

Wavelength Range for Calculation

Emission: [Green] 480nm-600nm, [Red] 560nm-680nm

Table 1 shows the EQE measurement results of the QD ink compositions obtained in reference example 3.

Table 1

| QD | TiO2 | Monomer mixture | Photo initiator | Antioxidant | EQE (%) |
|---|---|---|---|---|---|
| 40 | 5 | 53.2 (HDDMA:LA 40:60) | 1 | 0.8 | 25.2% |
| 40 | 5 | 53.2 (HDDMA:LA 30:70) | 1 | 0.8 | 24.8% |
| 40 | 5 | 53.2 (HDDMA:LA 20:80) | 1 | 0.8 | 24.6% |
| 40 | 5 | 53.2 (N DDA: LA 30:70) | 1 | 0.8 | 24.0% |
| (wt. %) | | | | | |

The EQE value of the QD ink composition obtained in the comparative example is 22.7.

**Reference example 6:** Preparation of QD ink composition

The QD ink composition is prepared in the same manner as described above with using the following materials.

| | |
|---|---|
| Green QD (Merck) | 40.0 wt.% |
| LA | 41.6 wt.% |
| HDDMA | 10.4 wt.% |
| Titanium dioxide (scattering particles) | 6.0 wt.% |
| Phosphine oxide, phenylbis(2,4,6-trimethylbenzoyl) (Omnirad(™) 819) | 1.0wt% |
| Irganox(™) 1010 | 1.0wt% |

**Reference example 7:** Preparation of Bank composition

The bank composition is prepared with using the following materials.

Table 2:

| | | |
|---|---|---|
| Alkaline soluble polymer | Acryl polymer A<br>Acryl polymer B | 6.4wt%<br>2.1wt% |
| Chemical compound (Monomer) | A-DPH (Shin-Nakamura) | 16.2wt% |
| Radical Initiator | NCI-831 (Adeka)<br>Irgacure 784 (BASF) | 0.26wt%<br>0.26wt% |
| Saccharide | Saccharide A | 7.7wt% |
| Surfactant | RS-72-K (DIC) | 0.08wt% |
| Solvent | PGMEA<br>GBL | 51.9wt%<br>13.0wt% |
| Colorant | Black Pigment | 2. 1wt% |
| Total | | 100% |
| Saccharide A: sucrose ethylene oxide adduct<br>Acryl polymer B: 2-Propenoic acid, 2-methyl-, polymer with 2-hydroxyethyl 2-methyl-2-propenoate, 2-isocyanatoethyl 2-propenoate and methyl 2-methyl-2-propenoate (Natoco).<br>Acryl polymer A: acrylic randam polymer made from carbon acid monomer and monomer containing at least one aromatic ring group (Shin-Nakajima). | | |

**Reference example** 8: Device fabrication

The obtained bank composition is applied onto a bared glass substrate by spin coating, then the coated glass substrate is prebaked on a hot plate at 100°C for 90 seconds so as to prepare an average film thickness of 13 μm. Exposure is performed using an i-line exposure machine, and cure baking is performed at 230°C for 30 min. Then, a development is performed using 0.03 % KOH for 60 seconds, and rinsing with deionaized pure water is performed for 30 seconds. As a result, a 12 μm bank (C/H) pattern is formed. Finally, sample 1 is obtained.

Then sample 2 is fabricated in the same manner as described above "fabrication of sample 1" except for 100°C for 30 minutes cure baking condition is applied instead of 230°C for 30 minutes cure baking condition. Then sample 2 is obtained.

- OD calculation

The transmittance at the wavelength of 400 to 700 nm of sample 1 and sample 2 are measured with using a Spectrophotometer CM-5 (Konica Minolta, Inc.), and it is converted into the OD.

- SEM analysis

Cross Section SEM analysis of the sample 2 is performed.
FT: 11.5μm, Taper angle: 98deg. are observed.

According to the Cross Section SEM analysis, the well-defined pixel structure is observed. It also proves that a low curing temperature (e.g. 100°C) properties of the bank is very good. Further, the bank composition is well developed even with a low-concentration alkaline developer

The process conditions and the obtained OD caluculation results are shown in Table 3. It is also confirmed by SEM analysis that the patterns of sample 1 and 2 are formed (OK) without any peeling.

Table 3

| | |
|---|---|
| Substrate | Bare glass |
| Surface treatment | No surface treatment |

(continued)

| | |
|---|---|
| Coating recipe | 900rpm/0.1s, 160rpm/10s, 1000rpm/0.1s |
| Bake | 100degC, 90sec. |
| Expo. | 100, 120 140mJ |
| Dev. | 0.03%KOH, 60sec |
| rinse | DIW 30s |
| Cure baking | 230degC(ref) or 100degC , air, 30min |
| Film thickness | After dev=13.0um/ After cure=12.0um |
| OD | OD1.96/FT12.0um (230degCcure Ref)<br>OD1.81/FT12.0um (100degC cure) |

-QD ink filing test

Then, the QD ink obtained in working example 14 is injected into the samples 1 and 2 with 12mm gap and photo-cured by irradiating UV light. The obtained samples 1 and 2 are very clear.

According to the cross section SEM analysis, a smooth layer structure without any void in a cured ink and without any aggregation in the cured ink is observed.

And the compartibility between the bank and the cured ink, and the wetting properties and chemical stability towards the QD ink are both very good.

Accroding to the SEM analysis, no dissolution, no delamination of the bank structure by the QD ink, no intermixing of the bank and the QD ink are also observed.

**Working Example 1:** Preparation of TiO2 stock in Lauryl acrylate (LA) 15.79 g of TiO2 in n-octane is mixed with 38.00 g of LA in a glass flask and n-octane in the mixture is evaporated by rotary evaporator under vacuum at 40 deg.C. Thus obtained the 20 wt.% TiO2 stock in LA.

**Working Example 2:** Preparation of Green QD ink with OA ($OA/QD_{inorg.}$ weight ratio = 0.06)

0.670 g of TiO2 stock in LA obtained in Working Example 1, 0.709 g of LA, 0.135 g of TMPTA, 8.93 g of green QD in n-octane (S-BG051, Shoei) and 0.054 g of OA are mixed in a glass flask. The mixture is stirred at 40 deg.C for 2 hours under N2 atmosphere, and then n-octane in the mixture is evaporated by rotary evaporator under vacuum at 40 deg.C. To this mixture 0.027 g of Omnirad819 and 0.013 g of Irganox1010 are added and the mixture is stirred at room temp. until the ink becomes homogeneous, thus obtained the green QD ink of the composition (Sample A-1 (OA:2wt%)) shown in the table below.

| Component | wt. ratio | g(NV) |
|---|---|---|
| LA | 45.5 | 1.218 |
| TMPTA | 5.1 | 0.135 |
| $TiO_2$ | 5.0 | 0.134 |
| Dispersant | 1.0 | 0.027 |
| Green QD in n-octane (SBG051) | 40.0 | 1.072 |
| Oleic acid (OA) | 2.0 | 0.054 |
| Omnirad(™) 819 | 1.0 | 0.027 |
| Irganox(™) 1010 | 0.5 | 0.013 |
| Total | 100.0 | 2.680 |

Sample A-2 (OA: 4wt% ) is prepared in the same manner as described above expect for that 4wt% of Oleic acid (OA) based on the total amount of the composition is used.

Sample A-3 (OA:0.5wt%) is prepared in the same manner as described above expect for that 0.5wt% of Oleic

acid (OA) based on the total amount of the composition is used.

**Comparative Example 1 for Working Example 2:** Preparation of Green QD ink without OA

0.525 g of TiO2 stock in LA obtained in Working Example 1, 0.593 g of LA, 0.110 g of TMPTA and 7.00 g of green QD in n-octane (SBG051, Shoei) are mixed in a glass flask and n-octane in the mixture is evaporated by rotary evaporator under vacuum at 40 deg.C. To this mixture 0.021 g of Omnirad819 and 0.011 g of Irganox1010 are added and the mixture is stirred at room temp. until the ink becomes homogeneous, thus obtained the green QD ink of the composition (Sample B).

**Working Example 3:** Ligand exchange of Red QD ink with OA ($OA/QD_{inorg.}$ weight ratio = 0.07)

6.0 g of Red QD in heptane (SRF180921-01-RED-02, Nanosys) is put in a glass flask and heptane is evaporated by rotary evaporator under vacuum at 40 deg.C. The dried QD is dissolved in 12.6 ml of anhydrous THF and to the solution 0.4 ml of OA is added. The mixture is heated to reflux under N2 atmosphere for 2 hours, and after cooling down the solution the red QD was precipitated out by adding 60 ml of dry acetone. Then the turbid solution is centrifuged at 6,000G for 5min. and supernatant is decanted. By complete dryness of the pellets under vacuum 1.23 g of the purified red QD powder is obtained. This purified red QD powder is dissolved in 3.51 g of dry n-octane to prepare 26 wt.% stock solution in n-octane.

**Working Example 4:** Preparation of Red QD ink with OA ($OA/QD_{inorg.}$ weight ratio = 0.07)

0.910 g of TiO2 stock in LA obtained in Working Example 1, 1.274 g of LA, 0.491 g of HDDA, 3.500 g of red QD in n-octane obtained in working example 3 (LE) are mixed in a glass flask and n-octane in the mixture is evaporated by rotary evaporator under vacuum at 40 deg.C. To this mixture 0.036 g of Omnirad819 and 0.018 g of Irganox1010 are added and the mixture is stirred at room temp. until the ink became homogeneous, thus obtained the red QD ink of the composition (Sample C) shown in the table below.

| Component | wt. ratio | g(NV) |
|---|---|---|
| LA | 54.0 | 1.966 |
| HDDA | 13.5 | 0.491 |
| $TiO_2$ | 5.0 | 0.182 |
| Dispersant | 1.0 | 0.036 |
| Red QD in n-octane (working example 3) | 25.0 | 0.910 |
| Omnirad(™) 819 | 1.0 | 0.036 |
| Irganox(™) 1010 | 0.5 | 0.018 |
| Total | 100.0 | 3.640 |

**Comparative Example 2 for Working Example 4:** Preparation of Red QD ink without OA

1.119 g of TiO2 stock in LA obtained in example 1, 1.264 g of LA, 0.906 g of HDDMA, 3.000 g of red QD in heptane (SRF180921-01-RED-02, Nanosys) are mixed in a glass flask and heptane in the mixture is evaporated by rotary evaporator under vacuum at 40 deg.C. To this mixture 0.045 g of Omnirad819 and 0.022 g of Irganox1010 are added and the mixture is stirred at room temp. until the ink became homogeneous, thus obtained the red QD ink of the composition (Sample D) shown in the table below.

| Component | wt. ratio | g(NV) |
|---|---|---|
| LA | 47.3 | 2.115 |
| HDDMA | 20.3 | 0.906 |
| $TiO_2$ | 5.0 | 0.224 |
| Dispersant | 1.0 | 0.045 |
| Red QD in heptane (no ligand exchange) | 25.0 | 1.119 |
| Omnirad(™) 819 | 1.0 | 0.045 |

(continued)

| Component | wt. ratio | g(NV) |
|---|---|---|
| Irganox(™) 1010 | 0.5 | 0.022 |
| Total | 100.0 | 4.476 |

**Working Example 5:** Measurement of viscosity trend of the Samples A, B, C and D

Viscosity trends of samples A1 to A3 and sample B are measured with using a viscometer (Viscomate VM-10A, Sekonic) at 25 deg.C in air. Fig. 6 shows the measurement results of Samples A1 to A3 of working example 2. Fig. 7 shows the measurement results of Sample B of comparative example 1. By adding Oleic acid (OA) into the QD ink composition, long term viscosity increase is significantly reduced/ prevented. And initial viscosity value of QD ink is also successfully reduced to a very preferable value for micro nozzle inkjet printing.

**Working Example 6:** Wiping Test

Sample A-1 from Working Example 2 and Sample E as a comparative example are used for Wiping Test. Following table shows the test results.

| | | Sample A (W.E.2: LA/TMPTA=90/10) | Sample D (ref) |
|---|---|---|---|
| Curing Time | 2sec | OK | Very soft |
| | 5sec | OK | Very soft |
| | 10sec | OK | Very soft |

UV curing condition: 100mW/$cm^2$ with 395nm UV LED under nitrogen flow (O2 concentration: 0.1%)

Sample E (comparative example):

| | Target | wt% |
|---|---|---|
| Green QD (SBG051) | 40wt% | **40** |
| LA | LA:HDDMA =70: 30 | **52** |
| HDDMA | 70:30 | |
| TiO2 | | **5** |
| Dispersant | 20wt% for SB | **1** |
| Omnirad(™) 819 | | **1** |
| Irganox(™) 1010 | | **1** |

## Claims

**1.** A composition comprising at least;

i) a (meth)acrylate monomer;
ii) a light emitting moiety; and
iii) a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid; wherein said (meth)acrylate monomer is represented by following chemical formula (II);

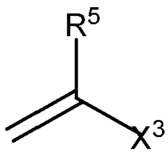

(II)

where the symbol $X^3$ is

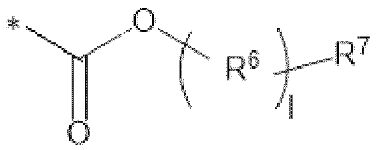

,

where "*" on the left side of the formula represents the connecting point to the end group $C=CR^5$ of the formula (I); l is 0 or 1 ;
$R^5$ is a hydrogen atom, halogen atom of Cl, Br, or F, methyl group, alkyl group, aryl group, alkoxy group;
$R^6$ is a straight alkylene chain or alkoxylene chain having 1 to 25 carbon atoms, preferably $R^6$ is a straight alkylene chain or alkoxylene chain having1 to 15 carbon atoms, more preferably 1 to 5 carbon atoms,
which may be substituted by one or more radicals $R^a$, where one or more H atoms may be replaced by D, F, Cl, Br, I, CN or $NO_2$;
$R^7$ is a straight alkylene chain or alkoxylene chain having 1 to 25 carbon atoms, preferably $R^7$ is a straight alkylene chain or alkoxylene chain having1 to 15 carbon atoms, more preferably 1 to 5 carbon atoms, which may be substituted by one or more radicals $R^a$, where one or more H atoms may be replaced by D, F, Cl, Br, I, CN or $NO_2$;
$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another;
wherein the composition further comprises a (meth)acrylate monomer represented by following chemical formula (I);

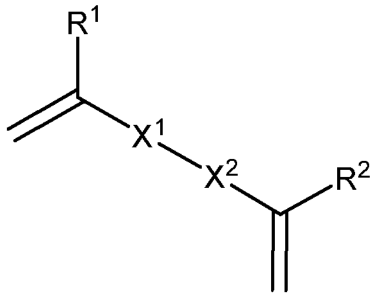

(I)

wherein

$R^1$ is a hydrogen atom, halogen atom of Cl, Br, or F, methyl group, alkyl group, aryl group, alkoxy group, ester group, or a carboxylic acid group;
$R^2$ is a hydrogen atom, halogen atom of Cl, Br, or F, methyl group, alkyl group, aryl group, alkoxy group, ester group, or a carboxylic acid group;
where the symbol $X^1$ is

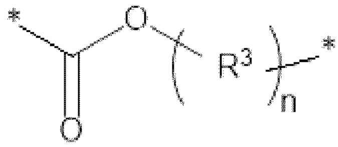

,

where "*" on the left side of the formula represents the connecting point to the carbon atom of the end group $C=CR^1$ of the formula (I) and "*" on the right side represents the connecting point to symbol $X^2$ of the formula (I); n is 0 or 1;
where the symbol $X^2$ is

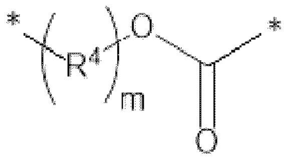

,

where "*" on the left side of the formula represents the connecting point to symbol X1 of the formula (I) and "*" on the right side represents the connecting point to the end group $C=CR^2$ of the formula (I);
m is 0 or 1;
preferably at least m or n is 1;
$R^3$ is a straight alkylene chain or alkoxylene chain having 1 to 25 carbon atoms, a cycloalkane having 3 to 25 carbon atoms or an aryl group having 3 to 25 carbon atoms, preferably $R^3$ is a straight alkylene chain or alkoxylene chain having1 to 15 carbon atoms, more preferably 1 to 5 carbon atoms,
which may be substituted by one or more radicals $R^a$, where one or more H atoms may be replaced by D, F, Cl, Br, I, CN or $NO_2$;
$R^4$ is a straight alkylene chain or alkoxylene chain having 1 to 25 carbon atoms, a cycloalkane having 3 to 25 carbon atoms or an aryl group having 3 to 25 carbon atoms, preferably $R^4$ is a straight alkylene chain or alkoxylene chain having1 to 15 carbon atoms, more preferably 1 to 5 carbon atoms,
which may be substituted by one or more radicals $R^a$, where one or more H atoms may be replaced by D, F, Cl, Br, I, CN or $NO_2$;
$R^a$ is at each occurrence, identically or differently, H, D or an alkyl group having 1 to 20 carbon atoms, cyclic alkyl or alkoxy group having 3 to 40 carbon atoms, an aromatic ring system having 5 to 60 carbon ring atoms, or a hetero aromatic ring system having 5 to 60 carbon atoms, wherein H atoms may be replaced by D, F, Cl, Br, I; two or more adjacent substituents $R^a$ here may also form a mono- or polycyclic, aliphatic, aromatic or heteroaromatic ring system with one another; and
wherein the chemical compound is represented by following chemical formula ($X^A$).

$$Z\text{-}Y\text{-} \qquad (X^A)$$

wherein

Z is *- $R^{x1}$ or

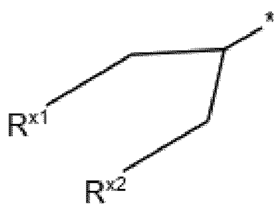

,

**where** "*" represents the connecting point to symbol Y of the formula, $R^{x1}$ is a group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid; and

$R^{x2}$ is a group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid;
Y is a straight-chain or branched alkyl group having carbon atoms 1 to 45, straight-chain or branched alkenyl group having carbon atoms 1 to 45 or straight-chain or branched alkoxyl group having carbon atoms 1 to 45.

2. The composition of claim 1, wherein Z of chemical formula ($X^A$) is *- $R^{x1}$.

3. The composition of claim 1 or 2, wherein the chemical compound can be selected from stearic acid, oleic acid, parmitic acid, dodecenoic acid, octadecylphosphonic acid, hexylphosphonic acid, monostearyl phosphate, didodecyl phosphate, monododecyl phosphate, didodecyl phosphate, their derivatives and a combination of any of these.

4. The composition of any one of claims 1 to 3, wherein the ratio of the total weight of the chemical compound to the total weight of the light emitting moiety is in the range 0.6:40 to 1:3.

5. The composition of any one of claims 1 to 4, wherein said $R^7$ of chemical formula (II) is selected from the following groups;

| | | |
|---|---|---|
| $*-(CH_2)_6-CH_3$ | $*- (CH_2)_7-CH_3$ | $*-(CH_2)_8-CH_3$ |
| $*-(CH_2)_9-CH_3$ | $*-(CH_2)_{10}-CH_3$ | $*-(CH_2)_{11}-CH_3$ |
| $*-(CH_2)_{12}-CH_3$ | $*-(CH_2)_4-OH$ | $*-(CH_2)_2-OH$ |
| $*-(CH_2)_6-OH$ | $*-(CH_2)_3-OH$ | $*-(CH_2)_5-OH$ |

wherein "*" represents the connecting point to $R^6$ of $X^3$ in case l is 1, and it is representing the connecting point to oxygen atom of $X^3$ of the formula (II) in case n is 0.

6. The composition of any one of claims 1 to 5, further comprises a (meth)acrylate monomer represented by following chemical formula (III);

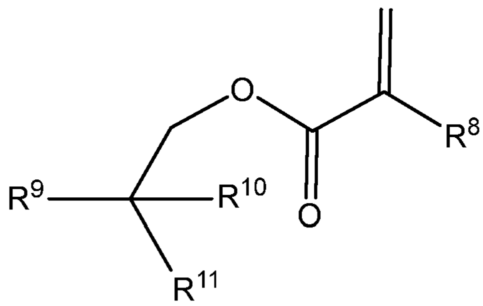

(III);

wherein $R^9$ is hydrogen atom, a straight alkyl group having 1 to 25 carbon atoms or a (meth)acryl group represented by chemical formula (IV)

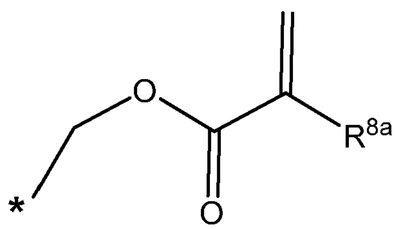

(IV);

$R^{10}$ is hydrogen atom, a straight alkyl group having 1 to 25 carbon atoms or a (meth)acryl group represented by chemical formula (V)

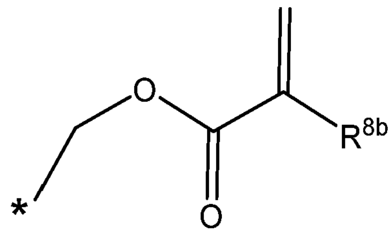

(V);

$R^{11}$ is hydrogen atom, a straight alkyl group having 1 to 25 carbon atoms or a (meth)acryl group represented by chemical formula (VI)

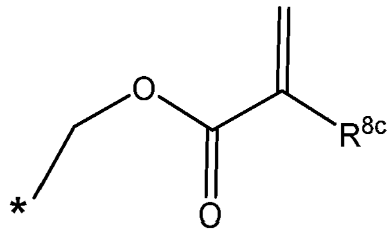

(VI);

wherein $R^{8a}$, $R^{8b}$ and $R^{8c}$ are, each independently or dependently of each other at each occurrence, H or $CH_3$; wherein at least one of $R^9$, $R^{10}$ and $R^{11}$ is a (meth)acryl group.

**7.** The composition of any one of claims 1 to 6, wherein the boiling point (B.P.) of said (meth)acrylate monomer of chemical formula (I) and/or chemical formula (II) is 250°C or more.

**8.** The composition of any one of claims 1 to 7, wherein the viscosity of the composition is 35 cP or less at room temperature as measured by the vibration type viscometer disclosed in the description

**9.** The composition of any one of claims 1 to 9, the composition is configured to show the EQE value 23% or more, preferably 24% or more and less than 95%, wherein said EQE is measured by the following EQE measurement process at room temperature which is based on using an integrating sphere, equipped with a 450nm excitation light source coupled in via an optical fiber, and a spectrometer disclosed in the description, and which consists of a first measurement using air as the reference to detect the incident photons of the excitation light and a second measurement with the sample or test cell placed in front of the integrating sphere in between the opening of the integrating sphere and the exit of the optical fiber to detect the photons incident from the excitation light source transmitted through the sample and the photos emitted from the sample or test cell, whereas for both cases photons exiting the integrating sphere are counted by the spectrometer and EQE and BL calculation is done with the following equations and the number of photons of the excitation light and emission light is calculated by integration over the following wavelength ranges;

EQE = Photons [Emission light] / Photons [Excitation light measured without sample in place];

BL = Photons [measured without sample in place] / Photons [Excitation light measured without sample in place];

Emission light if green light emitting moieties are used: 480nm-600nm,
Emission light if red light emitting moieties are used: 560nm-680nm
Excitation light: 430nm-470nm .

**10.** The composition of any one of claims 1 to 9, wherein the composition comprises a solvent 10wt% or less based on the total amount of the composition.

**11.** Process for fabricating the composition of any one of claims 1 to 10 comprising at least the following steps Y1 and Y2, preferably in this sequence, or the process comprises at least following step Y3;

Y1) mixing at least one light emitting moiety and a (meth)acrylate monomer to form a 1st composition;
Y2) mixing the 1st composition with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid, preferably said group is a phosphonate group, thiol group, a carboxyl group or a combination of any of these, more preferably it is a carboxyl group to form the composition; or
Y3) mixing at least one light emitting moiety and a (meth)acrylate monomer with a chemical compound comprising at least one group selected from one or more of members of the group consisting of phosphine group, phosphine oxide group, phosphate group, phosphonate group, thiol group, tertiary amine, carboxyl group, hetero cyclic group, silane group, sulfonic acid, hydroxyl group, phosphonic acid.

**12.** Process of fabricating a layer, wherein the process comprises at least the following steps;

I) providing a composition of any one of claims 1 to 10 onto a substrate,
II) curing the composition, preferably said curing is performed by photo irradiation and/or thermal treatment.

**13.** A layer obtained or obtainable from the process of claim 12.

**14.** A color conversion device (100) comprising at least a 1st pixel (161) partly or fully filled with the layer of claim 13 comprising at least a matrix material (120) containing a light emitting moiety (110), and a bank (150) comprising at least a polymer material, preferably the color conversion device (100) further contains a supporting medium (170).

**15.** An optical device (300) containing at least one functional medium (320, 420, 520) configured to modulate a light or configured to emit light, and the color conversion device (100) of claim 14.

## Patentansprüche

**1.** Zusammensetzung, zumindest umfassend;

i) ein (Meth)acrylat-Monomer;
ii) einen lichtemittierenden Teil; und
iii) eine chemische Verbindung, umfassend zumindest eine Gruppe, ausgewählt aus einem oder mehreren Mitgliedern der Gruppe, bestehend aus Phosphingruppe, Phosphinoxidgruppe, Phosphatgruppe, Phosphonatgruppe, Thiolgruppe, tertiärem Amin, Carboxylgruppe, heterozyklischen Gruppe, Silangruppe, Sulfonsäure, Hydroxylgruppe und Phosphonsäure;
wobei das (Meth)acrylat-Monomer durch die folgende chemische Formel (II) dargestellt wird;

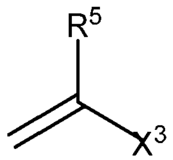

(II)

wo das Symbol $X^3$

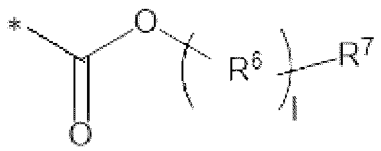

ist,
wobei "*" auf der linken Seite der Formel den Verbindungspunkt zu der Endgruppe $C=CR^5$ der Formel (I) darstellt;
l 0 oder 1 ist;
$R^5$ ein Wasserstoffatom, Halogenatom von Cl, Br oder F, Methylgruppe, Alkylgruppe, Arylgruppe, Alkoxygruppe ist; $R^6$ eine geradkettige Alkylenkette oder Alkoxylenkette mit 1 bis 25 Kohlenstoffatomen ist, vorzugsweise $R^6$

eine geradkettige Alkylenkette oder Alkoxylenkette mit 1 bis 15 Kohlenstoffatomen, besonders bevorzugt 1 bis 5 Kohlenstoffatomen ist,

welche durch einen oder mehrere Reste $R^a$ substituiert sein können, wo ein oder mehrere H-Atome durch D, F, Cl, Br, I, CN oder $NO_2$ ersetzt werden können;

$R^7$ eine gerade Alkylenkette oder Alkoxylenkette mit 1 bis 25 Kohlenstoffatomen ist, vorzugsweise $R^7$ eine gerade Alkylenkette oder Alkoxylenkette mit 1 bis 15 Kohlenstoffatomen, besonders bevorzugt 1 bis 5 Kohlenstoffatome ist, welche durch einen oder mehrere Reste $R^a$ substituiert sein können, wo ein oder mehrere H-Atome durch D, F, Cl, Br, I, CN oder $NO_2$ ersetzt sein können;

$R^a$ bei jedem Auftreten, gleich oder unterschiedlich, H, D oder eine Alkylgruppe mit 1 bis 20 Kohlenstoffatomen, eine zyklische Alkyl- oder Alkoxygruppe mit 3 bis 40 Kohlenstoffatomen, ein aromatisches Ringsystem mit 5 bis 60 Kohlenstoffringatomen oder ein heteroaromatisches Ringsystem mit 5 bis 60 Kohlenstoffatomen ist, wobei H-Atome durch D, F, Cl, Br, I ersetzt sein können; zwei oder mehr benachbarte Substituenten $R^a$ können hier auch miteinander ein mono- oder polyzyklisches, aliphatisches, aromatisches oder heteroaromatisches Ringsystem bilden;

wobei die Zusammensetzung ferner ein (Meth)acrylat-Monomer umfasst, das durch die folgende chemische Formel (I) dargestellt ist;

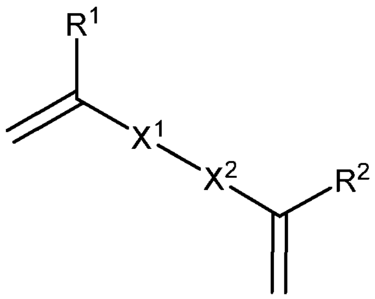

(I)

wobei

$R^1$ ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

R2 ein Wasserstoffatom, Halogenatom von Cl, Br oder F, eine Methylgruppe, Alkylgruppe, Arylgruppe, Alkoxygruppe, Estergruppe oder eine Carbonsäuregruppe ist;

wo das Symbol $X^1$

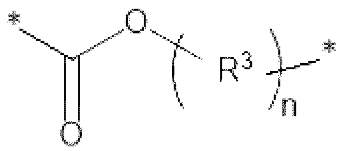

ist, wo "*" auf der linken Seite der Formel den Verbindungspunkt zu dem Kohlenstoffatom der Endgruppe $C=CR^1$ der Formel (I) darstellt und "*" auf der rechten Seite den Verbindungspunkt zu dem Symbol $X^2$ der Formel (I) darstellt; n 0 oder 1 ist;

wo das Symbol $X^2$

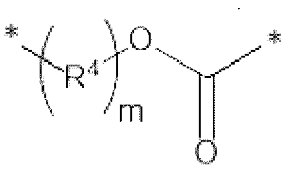

ist,

wobei "*" auf der linken Seite der Formel den Verbindungspunkt zu Symbol X1 der Formel (I) darstellt und "*" auf der rechten Seite den Verbindungspunkt zu der Endgruppe $C=CR^2$ der Formel (I) darstellt;

m 0 oder 1 ist;

vorzugsweise zumindest m oder n gleich 1 ist;

$R^3$ eine geradkettige Alkylenkette oder Alkoxylenkette mit 1 bis 25 Kohlenstoffatomen, ein Cycloalkan mit 3 bis 25 Kohlenstoffatomen oder eine Arylgruppe mit 3 bis 25 Kohlenstoffatomen ist, vorzugsweise $R^3$ eine geradkettige Alkylenkette oder Alkoxylenkette mit 1 bis 15 Kohlenstoffatomen, besonders bevorzugt 1 bis 5 Kohlenstoffatomen ist,

welche durch einen oder mehrere Reste $R^a$ substituiert sein können, wo ein oder mehrere H-Atome durch D, F, Cl, Br, I, CN oder $NO_2$ ersetzt werden können;

$R^4$ eine geradkettige Alkylenkette oder Alkoxylenkette mit 1 bis 25 Kohlenstoffatomen, ein Cycloalkan mit 3 bis 25 Kohlenstoffatomen oder eine Arylgruppe mit 3 bis 25 Kohlenstoffatomen ist, vorzugsweise $R^4$ eine geradkettige Alkylenkette oder Alkoxylenkette mit 1 bis 15 Kohlenstoffatomen, besonders bevorzugt 1 bis 5 Kohlenstoffatomen ist,

welche durch einen oder mehrere Reste $R^a$ substituiert sein können, wo ein oder mehrere H-Atome durch D, F, Cl, Br, I, CN oder $NO_2$ ersetzt werden können;

$R^a$ bei jedem Auftreten, gleich oder unterschiedlich, H, D oder eine Alkylgruppe mit 1 bis 20 Kohlenstoffatomen, eine zyklische Alkyl- oder Alkoxygruppe mit 3 bis 40 Kohlenstoffatomen, ein aromatisches Ringsystem mit 5 bis 60 Kohlenstoffringatomen oder ein heteroaromatisches Ringsystem mit 5 bis 60 Kohlenstoffatomen ist, wobei H-Atome durch D, F, Cl, Br, I ersetzt sein können; zwei oder mehr benachbarte Substituenten $R^a$ können hier auch miteinander ein mono- oder polyzyklisches, aliphatisches, aromatisches oder heteroaromatisches Ringsystem bilden; und

wobei die chemische Verbindung durch die folgende chemische Formel ($X^A$) dargestellt wird

Z-Y - ($X^A$)

wobei

Z *- $R^{x1}$ oder

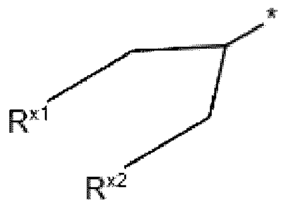

ist, wo "*" den Verbindungspunkt zu dem Symbol Y der Formel darstellt, $R^{x1}$ eine Gruppe ist, ausgewählt aus einem oder mehreren Mitgliedern der Gruppe, bestehend aus Phosphingruppe, Phosphinoxidgruppe, Phosphatgruppe, Phosphonatgruppe, Thiolgruppe, tertiärem Amin, Carboxylgruppe, heterozyklische Gruppe, Silangruppe, Sulfonsäure, Hydroxylgruppe, Phosphonsäure; und

$R^{x2}$ eine Gruppe ist, ausgewählt aus einem oder mehreren Mitgliedern der Gruppe, bestehend aus Phosphingruppe, Phosphinoxidgruppe, Phosphatgruppe, Phosphonatgruppe, Thiolgruppe, tertiärem Amin, Carboxylgruppe, heterozyklischen Gruppe, Silangruppe, Sulfonsäure, Hydroxylgruppe und Phosphonsäure;

Y eine geradkettige oder verzweigte Alkylgruppe mit 1 bis 45 Kohlenstoffatomen, eine geradkettige oder verzweigte Alkenylgruppe mit 1 bis 45 Kohlenstoffatomen oder eine geradkettige oder verzweigte Alkoxylgruppe mit 1 bis 45 Kohlenstoffatomen ist.

2. Zusammensetzung nach Anspruch 1, wobei Z der chemischen Formel ($X^A$) *- $R^{x1}$ ist.

3. Zusammensetzung nach Anspruch 1 oder 2, wobei die chemische Verbindung ausgewählt werden kann aus Stearinsäure, Ölsäure, Parmitsäure, Dodecensäure, Octadecylphosphonsäure, Hexylphosphonsäure, Monostearylphosphat, Didodecylphosphat, Monododecylphosphat, Didodecylphosphat, deren Derivaten und einer Kombination aus beliebigen dieser.

4. Zusammensetzung nach einem der Ansprüche 1 bis 3, wobei das Verhältnis des Gesamtgewichts der chemischen Verbindung zu dem Gesamtgewicht des lichtemittierenden Teils im Bereich von 0,6:40 bis 1:3 liegt.

5. Zusammensetzung nach einem der Ansprüche 1 bis 4, wobei das $R^7$ der chemischen Formel (II) ausgewählt ist aus den folgenden Gruppen;

| | | |
|---|---|---|
| $*-(CH_2)_6-CH_3$ | $*-(CH_2)_7-CH_3$ | $*-(CH_2)_8-CH_3$ |
| $*-(CH_2)_9-CH_3$ | $*-(CH_2)_{10}-CH_3$ | $*-(CH_2)_{11}-CH_3$ |
| $*-(CH_2)_{12}-CH_3$ | $*-(CH_2)_4-OH$ | $*-(CH_2)_2-OH$ |
| $*-(CH_2)_6-OH$ | $*-(CH_2)_3-OH$ | $*-(CH_2)_5-OH$ |

wobei "*" den Verbindungspunkt zu $R^6$ von $X^3$ darstellt, wenn l 1 ist, und es den Verbindungspunkt zu dem Sauerstoffatom von $X^3$ der Formel (II) darstellt, wenn n 0 ist.

**6.** Zusammensetzung nach einem der Ansprüche 1 bis 5, die ferner ein (Meth)acrylat-Monomer umfasst, das durch die folgende chemische Formel (III) dargestellt wird;

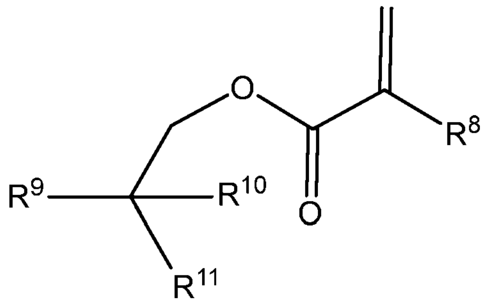

(III);

wobei $R^9$ ein Wasserstoffatom, eine geradkettige Alkylgruppe mit 1 bis 25 Kohlenstoffatomen oder eine (Meth) acrylgruppe der chemischen Formel (IV) ist

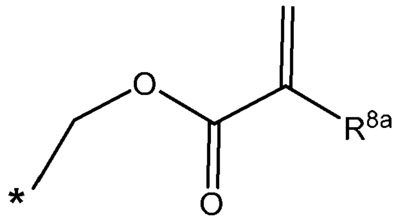

(IV);

$R^{10}$ ein Wasserstoffatom, eine gerade Alkylgruppe mit 1 bis 25 Kohlenstoffatomen oder eine (Meth)acrylgruppe ist, die durch die chemische Formel (V) dargestellt wird

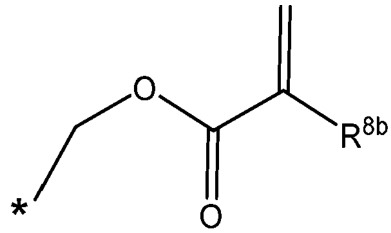

(V);

$R^{11}$ ein Wasserstoffatom, eine gerade Alkylgruppe mit 1 bis 25 Kohlenstoffatomen oder eine (Meth)acrylgruppe, die durch die chemische Formel (VI) dargestellt ist, ist

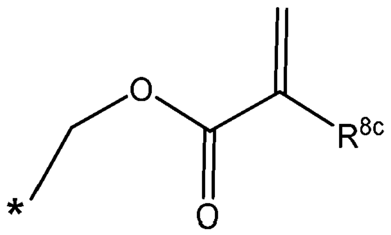

(VI);

wobei $R^{8a}$, $R^{8b}$ und $R^{8c}$ jeweils unabhängig voneinander oder in Abhängigkeit voneinander bei jedem Vorkommen H oder $CH_3$ sind;
wobei zumindest eines von $R_9$, $R^{10}$ und $R^{11}$ eine (Meth)acrylgruppe ist.

7. Zusammensetzung nach einem der Ansprüche 1 bis 6, wobei der Siedepunkt (B.P.) des (Meth)acrylat-Monomers der chemischen Formel (I) und/oder der chemischen Formel (II) 250 °C oder mehr beträgt.

8. Zusammensetzung nach einem der Ansprüche 1 bis 7, wobei die Viskosität der Zusammensetzung bei Raumtemperatur 35 cP oder weniger beträgt, gemessen mit dem in der Beschreibung offengelegten Viskosimeter vom Vibrationstyp.

9. Zusammensetzung nach einem der Ansprüche 1 bis 9, wobei die Zusammensetzung konfiguriert ist, um einen EQE-Wert von 23 % oder mehr, vorzugsweise 24 % oder mehr und weniger als 95 % aufzuweisen, wobei der EQE durch den folgenden EQE-Messvorgang bei Raumtemperatur gemessen wird, welcher auf der Verwendung einer Ulbricht-Kugel, die mit einer über eine optische Faser eingekoppelten 450-nm-Anregungslichtquelle ausgestattet ist, und einem in der Beschreibung offengelegten Spektrometer basiert, und welcher aus einer ersten Messung, bei der Luft als Referenz verwendet wird, um die einfallenden Photonen des Anregungslichts zu erfassen, und einer zweiten Messung besteht, bei der die Probe oder die Testzelle vor der Ulbricht-Kugel zwischen der Öffnung der Ulbricht-Kugel und dem Ausgang der optischen Faser angeordnet ist, um die von der Anregungslichtquelle einfallenden Photonen, die durch die Probe übertragen werden, und die von der Probe oder der Testzelle emittierten Photos zu erfassen, wogegen in beiden Fällen die aus der Ulbricht-Kugel austretenden Photonen vom Spektrometer gezählt, und die EQE- und BL-Berechnung anhand der folgenden Gleichungen erfolgt und die Anzahl der Photonen des Anregungslichts und des Emissionslichts durch Integration über die folgenden Wellenlängenbereiche berechnet wird;

EQE = Photonen [Emissionslicht] / Photonen [Anregungslicht, gemessen ohne Probe vor Ort];

BL = Photonen [gemessen ohne Probe vor Ort] / Photonen [Anregungslicht gemessen ohne Probe vor Ort];

Emissionslicht, falls grünes Licht emittierende Teile verwendet werden: 480 nm-600 nm, Emissionslicht, falls rotes Licht emittierende Teile verwendet werden: 560 nm-680 nm Anregungslicht: 430 nm-470 nm.

10. Zusammensetzung nach einem der Ansprüche 1 bis 9, wobei die Zusammensetzung ein Lösungsmittel von 10 Gew.-% oder weniger umfasst, bezogen auf die Gesamtmenge der Zusammensetzung.

11. Vorgang zum Herstellen der Zusammensetzung nach einem der Ansprüche 1 bis 10, umfassend zumindest die folgenden Schritte Y1 und Y2, vorzugsweise in dieser Reihenfolge, oder der Vorgang umfasst zumindest den folgenden Schritt Y3;

Y1) Mischen zumindest eines lichtemittierenden Teils und eines (Meth)acrylat-Monomers zum Bilden einer 1. Zusammensetzung;
Y2) Mischen der 1. Zusammensetzung mit einer chemischen Verbindung, umfassend zumindest eine Gruppe, ausgewählt aus einem oder mehreren Mitgliedern der Gruppe, bestehend aus Phosphingruppe, Phosphinoxidgruppe, Phosphatgruppe, Phosphonatgruppe, Thiolgruppe, tertiärem Amin, Carboxylgruppe, heterozyklischer Gruppe, Silangruppe, Sulfonsäure, Hydroxylgruppe, Phosphonsäure, wobei die Gruppe vorzugsweise eine Phosphonatgruppe, Thiolgruppe, eine Carboxylgruppe oder eine Kombination aus einer dieser Gruppen, besonders bevorzugt eine Carboxylgruppe ist, um die Zusammensetzung zu bilden; oder
Y3) Mischen zumindest eines lichtemittierenden Teils und eines (Meth)acrylat-Monomers mit einer chemischen Verbindung, umfassend zumindest eine Gruppe, ausgewählt aus einem oder mehreren Mitgliedern der Gruppe,

bestehend aus Phosphingruppe, Phosphinoxidgruppe, Phosphatgruppe, Phosphonatgruppe, Thiolgruppe, tertiärem Amin, Carboxylgruppe, heterozyklischen Gruppe, Silangruppe, Sulfonsäure, Hydroxylgruppe und Phosphonsäure.

**12.** Vorgang zum Herstellen einer Schicht, wobei der Vorgang zumindest die folgenden Schritte umfasst;

I) Bereitstellen einer Zusammensetzung nach einem der Ansprüche 1 bis 10 auf einem Substrat,
II) Aushärten der Zusammensetzung, wobei das Aushärten vorzugsweise durch Fotostrahlung und/oder Wärmebehandlung durchgeführt wird.

**13.** Schicht, die durch den Vorgang nach Anspruch 12 erhalten wird oder erhältlich ist.

**14.** Farbumwandlungsvorrichtung (100), die zumindest ein 1. Pixel (161) umfasst, das teilweise oder vollständig mit der Schicht nach Anspruch 13 gefüllt ist, umfassend zumindest ein Matrixmaterial (120), enthaltend einen lichtemittierenden Teil (110), und eine Reihe (150), umfassend zumindest ein Polymermaterial, wobei die Farbumwandlungsvorrichtung (100) vorzugsweise ferner ein Trägermedium (170) enthält.

**15.** Optische Vorrichtung (300), enthaltend zumindest ein funktionelles Medium (320, 420, 520), konfiguriert, um Licht zu modulieren oder Licht zu emittieren, und die Farbumwandlungsvorrichtung (100) nach Anspruch 14.

## Revendications

**1.** Composition comprenant au moins ;

i) un monomère de (méth)acrylate ;
ii) une fraction émettrice de lumière ; et
iii) un composé chimique comprenant au moins un groupe choisi parmi un ou plusieurs des membres du groupe constitué par un groupe phosphine, un groupe oxyde de phosphine, un groupe phosphate, un groupe phosphonate, un groupe thiol, une amine tertiaire, un groupe carboxyle, un groupe hétérocyclique, un groupe silane, un acide sulfonique, un groupe hydroxyle, un acide phosphonique ;
dans laquelle ledit monomère de (méth)acrylate est représenté par la formule chimique (II) suivante ;

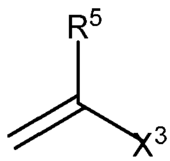

(II)

où le symbole $X^3$ est

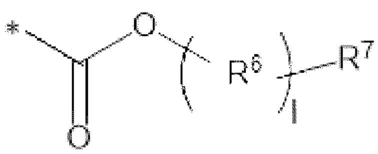

,

où « * » sur le côté gauche de la formule représente le point de liaison au groupe d'extrémité $C=CR^5$ de la formule (I) ;
l vaut 0 ou 1 ;
$R^5$ est un atome d'hydrogène, un atome d'halogène de Cl, Br ou F, un groupe méthyle, un groupe alkyle, un groupe aryle, un groupe alcoxy ;
$R^6$ est une chaîne alkylène ou une chaîne alcoxylène linéaire comportant 1 à 25 atomes de carbone, de préférence $R^6$ est une chaîne alkylène ou une chaîne alcoxylène linéaire comportant 1 à 15 atomes de carbone, idéalement 1 à 5 atomes de carbone, qui peut être substituée par un ou plusieurs radicaux $R^a$, où un ou plusieurs atomes H peuvent être remplacés par D, F, Cl, Br, I, CN ou $NO_2$ ;
$R^7$ est une chaîne alkylène ou une chaîne alcoxylène linéaire comportant 1 à 25 atomes de carbone, de

préférence $R^7$ est une chaîne alkylène ou une chaîne alcoxylène linéaire comportant 1 à 15 atomes de carbone, idéalement 1 à 5 atomes de carbone, qui peut être substituée par un ou plusieurs radicaux $R^a$, où un ou plusieurs atomes H peuvent être remplacés par D, F, Cl, Br, I, CN ou $NO_2$ ;

$R^a$ est, à chaque occurrence, de manière identique ou différente, H, D ou un groupe alkyle comportant 1 à 20 atomes de carbone, un groupe alkyle ou alcoxy cyclique comportant 3 à 40 atomes de carbone, un système de cycle aromatique comportant 5 à 60 atomes de carbone de cycle, ou un système de cycle hétéroaromatique comportant 5 à 60 atomes de carbone, lesdits atomes H pouvant être remplacés par D, F, Cl, Br, I ; deux substituants adjacents $R^a$ ou plus peuvent également former ici un système de cycle mono- ou polycyclique, aliphatique, aromatique ou hétéroaromatique entre eux ;

ladite composition comprenant en outre un monomère de (méth)acrylate représenté par la formule chimique (I) suivante ;

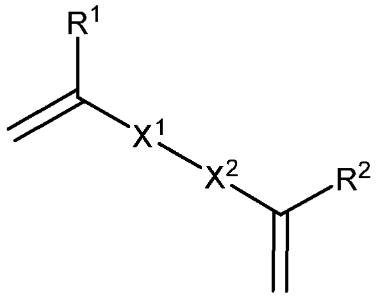

(I)

où

$R^1$ est un atome d'hydrogène, un atome d'halogène de Cl, Br ou F, un groupe méthyle, un groupe alkyle, un groupe aryle, un groupe alcoxy, un groupe ester ou un groupe acide carboxylique ;

$R^2$ est un atome d'hydrogène, un atome d'halogène de Cl, Br ou F, un groupe méthyle, un groupe alkyle, un groupe aryle, un groupe alcoxy, un groupe ester ou un groupe acide carboxylique ;

où le symbole $X^1$ est

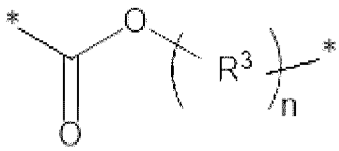

,

où « * » sur le côté gauche de la formule représente le point de liaison à l'atome de carbone du groupe d'extrémité $C=CR^1$ de la formule (I) et « * » sur le côté droit représente le point de liaison au symbole $X^2$ de la formule (I) ;

n vaut 0 ou 1 ;

où le symbole $X^2$ est

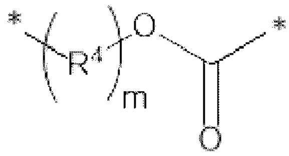

,

où « * » sur le côté gauche de la formule représente le point de liaison au symbole X1 de la formule (I) et « * » sur le côté droit représente le point de liaison au groupe d'extrémité $C=CR^2$ de la formule (I) ;

m vaut 0 ou 1 ;

de préférence au moins m ou n vaut 1 ;

$R^3$ est une chaîne alkylène ou une chaîne alcoxylène linéaire comportant 1 à 25 atomes de carbone, un cycloalcane comportant 3 à 25 atomes de carbone ou un groupe aryle comportant 3 à 25 atomes de carbone, de préférence $R^3$ est une chaîne alkylène ou une chaîne alcoxylène linéaire comportant 1 à 15 atomes de carbone, idéalement 1 à 5 atomes de carbone,

qui peut être substituée par un ou plusieurs radicaux $R^a$, où un ou plusieurs atomes H peuvent être remplacés par D, F, Cl, Br, I, CN ou $NO_2$ ;

$R^4$ est une chaîne alkylène ou une chaîne alcoxylène linéaire comportant 1 à 25 atomes de carbone, un cycloalcane comportant 3 à 25 atomes de carbone ou un groupe aryle comportant 3 à 25 atomes de carbone, de préférence $R^4$ est une chaîne alkylène ou une chaîne alcoxylène linéaire comportant 1 à 15 atomes de carbone, idéalement 1 à 5 atomes de carbone,
qui peut être substituée par un ou plusieurs radicaux $R^a$, où un ou plusieurs atomes H peuvent être remplacés par D, F, Cl, Br, I, CN ou $NO_2$ ;
$R^a$ est, à chaque occurrence, de manière identique ou différente, H, D ou un groupe alkyle comportant 1 à 20 atomes de carbone, un groupe alkyle ou alcoxy cyclique comportant 3 à 40 atomes de carbone, un système de cycle aromatique comportant 5 à 60 atomes de carbone de cycle, ou un système de cycle hétéroaromatique comportant 5 à 60 atomes de carbone, lesdits atomes H pouvant être remplacés par D, F, Cl, Br, I ; deux substituants adjacents $R^a$ ou plus peuvent également former ici un système de cycle mono- ou polycyclique, aliphatique, aromatique ou hétéroaromatique entre eux ; et
dans laquelle le composé chimique est représenté par la formule chimique ($X^A$) suivante,

Z-Y- ($X^A$)

où

Z est *-$R^{x1}$ ou

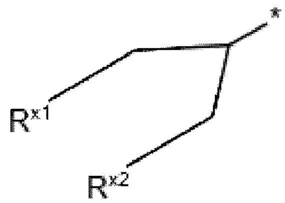

,

où « * » représente le point de liaison au symbole Y de la formule, $R^{x1}$ est un groupe choisi parmi un ou plusieurs des membres du groupe constitué par un groupe phosphine, un groupe oxyde de phosphine, un groupe phosphate, un groupe phosphonate, un groupe thiol, une amine tertiaire, un groupe carboxyle, un groupe hétérocyclique, un groupe silane, un acide sulfonique, un groupe hydroxyle, un acide phosphonique ; et
$R^{x2}$ est un groupe choisi parmi un ou plusieurs des membres du groupe constitué par un groupe phosphine, un groupe oxyde de phosphine, un groupe phosphate, un groupe phosphonate, un groupe thiol, une amine tertiaire, un groupe carboxyle, un groupe hétérocyclique, un groupe silane, un acide sulfonique, un groupe hydroxyle, un acide phosphonique ;
Y est un groupe alkyle à chaîne linéaire ou ramifiée comportant 1 à 45 atomes de carbone, un groupe alcényle à chaîne linéaire ou ramifiée comportant 1 à 45 atomes de carbone ou un groupe alcoxyle à chaîne linéaire ou ramifiée comportant 1 à 45 atomes de carbone.

2. Composition de la revendication 1, dans laquelle Z de la formule chimique ($X^A$) est *-$R^{x1}$.

3. Composition de l'une des revendications 1 ou 2, dans laquelle le composé chimique peut être choisi parmi l'acide stéarique, l'acide oléique, l'acide parmitique, l'acide dodécénoïque, l'acide octadécylphosphonique, l'acide hexylphosphonique, le phosphate de monostéaryle, le phosphate de didodécyle, le phosphate de monododécyle, le phosphate de didodécyle, leurs dérivés et une combinaison de n'importe lesquels de ceux-ci.

4. Composition de l'une quelconque des revendications 1 à 3, dans laquelle le rapport du poids total du composé chimique au poids total de la fraction émettrice de lumière est compris dans la plage de 0,6:40 à 1:3.

5. Composition de l'une quelconque des revendications 1 à 4, dans laquelle ledit $R^7$ de la formule chimique (II) est choisi parmi les groupes suivants ;

| | | |
|---|---|---|
| *-$(CH_2)_6$-$CH_3$ | *-$(CH_2)_7$-$CH_3$ | *-$(CH_2)_8$-$CH_3$ |
| *-$(CH_2)_9$-$CH_3$ | *-$(CH_2)_{10}$-$CH_3$ | *-$(CH_2)_{11}$-$CH_3$ |

(continued)

| | | |
|---|---|---|
| *-$(CH_2)_{12}$-$CH_3$ | *-$(CH_2)_4$-OH | *-$(CH_2)_2$-OH |
| *-$(CH_2)_6$-OH | *-$(CH_2)_3$-OH | *-$(CH_2)_5$-OH |

où « * » représente le point de liaison à $R^6$ de $X^3$ dans le cas où l vaut 1, et représente le point de liaison à un atome d'oxygène de $X^3$ de la formule (II) dans le cas où n vaut 0.

6. Composition de l'une quelconque des revendications 1 à 5, comprenant en outre un monomère de (méth)acrylate représenté par la formule chimique (III) suivante ;

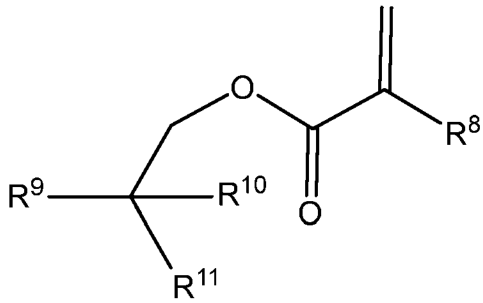

(III);

où $R^9$ est un atome d'hydrogène, un groupe alkyle linéaire comportant de 1 à 25 atomes de carbone ou un groupe (méth)acrylique représenté par la formule chimique (IV)

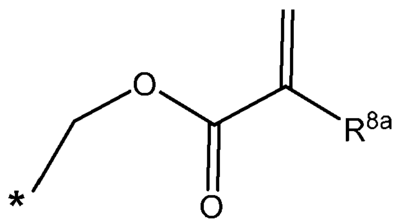

(IV);

$R^{10}$ est un atome d'hydrogène, un groupe alkyle linéaire comportant 1 à 25 atomes de carbone ou un groupe (méth)acrylique représenté par la formule chimique (V)

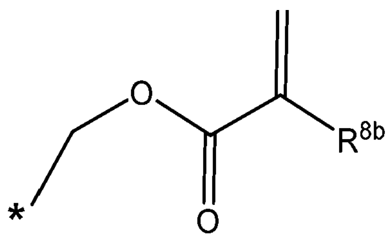

(V);

$R^{11}$ est un atome d'hydrogène, un groupe alkyle linéaire comportant 1 à 25 atomes de carbone ou un groupe (méth)acrylique représenté par la formule chimique (VI)

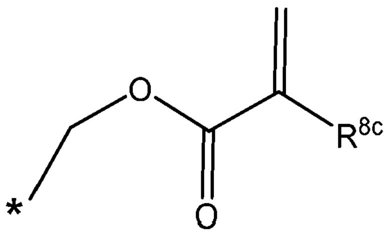

(VI);

où $R^{8a}$, $R^{8b}$ et $R^{8c}$ sont, chacun indépendamment ou dépendamment les uns des autres, à chaque occurrence, H ou $CH_3$ ;
où au moins l'un de $R^9$, $R^{10}$ et $R^{11}$ est un groupe (méth)acrylique.

**7.** Composition de l'une quelconque des revendications 1 à 6, dans laquelle le point d'ébullition (PB) dudit monomère de (méth)acrylate de formule chimique (I) et/ou de formule chimique (II) est de 250 °C ou plus.

**8.** Composition de l'une quelconque des revendications 1 à 7, dans laquelle la viscosité de la composition est de 35 cP ou moins à température ambiante telle que mesurée par le viscosimètre de type à vibration décrit dans la description.

**9.** Composition de l'une quelconque des revendications 1 à 9, la composition est conçue pour présenter la valeur d'EQE de 23 % ou plus, de préférence de 24 % ou plus et de moins de 95 %, dans laquelle ladite EQE est mesurée par le processus de mesure d'EQE suivant à température ambiante qui est basé sur l'utilisation d'une sphère d'intégration, équipée d'une source de lumière d'excitation à 450 nm couplée par l'intermédiaire d'une fibre optique, et d'un spectrophotomètre décrit dans la description, et qui est constitué d'une première mesure utilisant l'air comme référence pour détecter les photons incidents de la lumière d'excitation et d'une seconde mesure avec l'échantillon ou la cellule d'essai placé(e) devant la sphère d'intégration entre l'ouverture de la sphère d'intégration et la sortie de la fibre optique pour détecter les photons incidents issus de la source de lumière d'excitation transmis à travers l'échantillon et les photos émis par l'échantillon ou la cellule d'essai, alors que dans les deux cas, les photons sortant de la sphère d'intégration sont comptés par le spectrophotomètre et le calcul de l'EQE et du BL est effectué selon les équations suivantes et le nombre de photons de la lumière d'excitation et de la lumière d'émission est calculé par intégration sur les plages de longueurs d'onde suivantes ;

EQE = Photons [Lumière d'émission]/Photons [Lumière d'excitation mesurée sans échantillon en place] ;

BL = Photons [mesurés sans échantillon en place]/Photons [Lumière d'excitation mesurée sans échantillon en place] ;

Lumière d'émission si des fractions émettrices de lumière verte sont utilisées : 480 nm-600 nm,
Lumière d'émission si des fractions émettrices de lumière rouge sont utilisées : 560 nm-680 nm
Lumière d'excitation : 430 nm-470 nm.

**10.** Composition de l'une quelconque des revendications 1 à 9, ladite composition comprenant un solvant de 10 % en poids ou moins sur la base de la quantité totale de la composition.

**11.** Processus pour la fabrication de la composition de l'une quelconque des revendications 1 à 10, comprenant au moins les étapes suivantes Y1 et Y2, de préférence dans cette séquence, ou le processus comprend au moins l'étape Y3 suivante ;

Y1) mélange d'au moins une fraction émettrice de lumière et d'un monomère de (méth)acrylate pour former une 1ère composition ;
Y2) mélange de la 1ère composition avec un composé chimique comprenant au moins un groupe choisi parmi un ou plusieurs des membres du groupe constitué par un groupe phosphine, un groupe oxyde de phosphine, un groupe phosphate, un groupe phosphonate, un groupe thiol, une amine tertiaire, un groupe carboxyle, un groupe hétérocyclique, un groupe silane, un acide sulfonique, un groupe hydroxyle, un acide phosphonique, de préférence ledit groupe est un groupe phosphonate, un groupe thiol, un groupe carboxyle ou une combinaison

de n'importe lesquels de ceux-ci, idéalement un groupe carboxyle pour former la composition ; ou
Y3) mélange d'au moins une fraction émettrice de lumière et d'un monomère de (méth)acrylate avec un composé chimique comprenant au moins un groupe choisi parmi un ou plusieurs des membres du groupe constitué par un groupe phosphine, un groupe oxyde de phosphine, un groupe phosphate, un groupe phosphonate, un groupe thiol, une amine tertiaire, un groupe carboxyle, un groupe hétérocyclique, un groupe silane, un acide sulfonique, un groupe hydroxyle, un acide phosphonique.

**12.** Processus de fabrication d'une couche, ledit processus comprenant au moins les étapes suivantes ;

I) fourniture d'une composition de l'une quelconque des revendications 1 à 10 sur un substrat,
II) durcissement de la composition, de préférence ledit durcissement est effectué par photo-irradiation et/ou traitement thermique.

**13.** Couche obtenue ou pouvant être obtenue à partir du processus de la revendication 12.

**14.** Dispositif de conversion de couleur (100) comprenant au moins un 1er pixel (161) partiellement ou entièrement rempli de la couche de la revendication 13, comprenant au moins un matériau de matrice (120) contenant une fraction émettrice de lumière (110), et une barrière (150) comprenant au moins un matériau polymère, de préférence, le dispositif de conversion de couleur (100) contient en outre un milieu de support (170).

**15.** Dispositif optique (300) contenant au moins un milieu fonctionnel (320, 420, 520) conçu pour moduler une lumière ou conçu pour émettre une lumière, et le dispositif de conversion de couleur (100) de la revendication 14.

Fig. 1

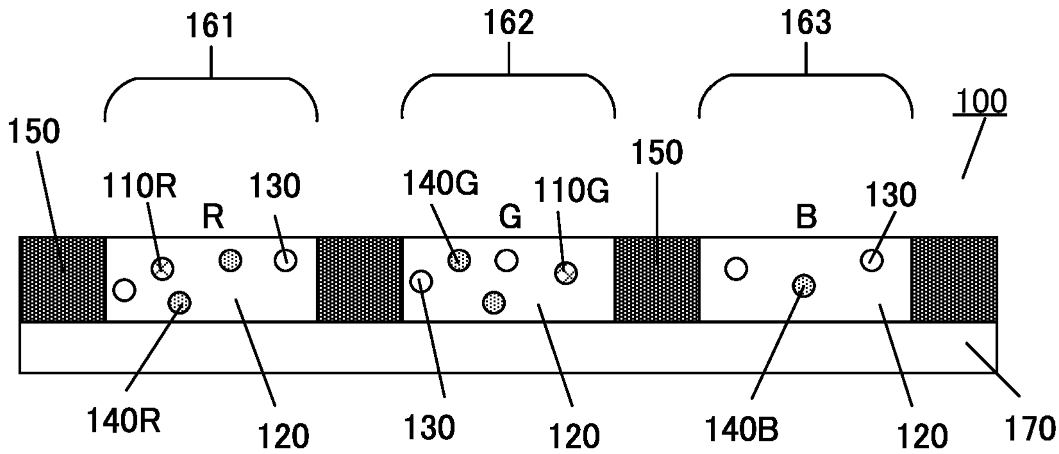
161
162
163
100
150
110R
R
130
140G
G
110G
150
B
130
140R
120
130
120
140B
120
170

Fig. 2

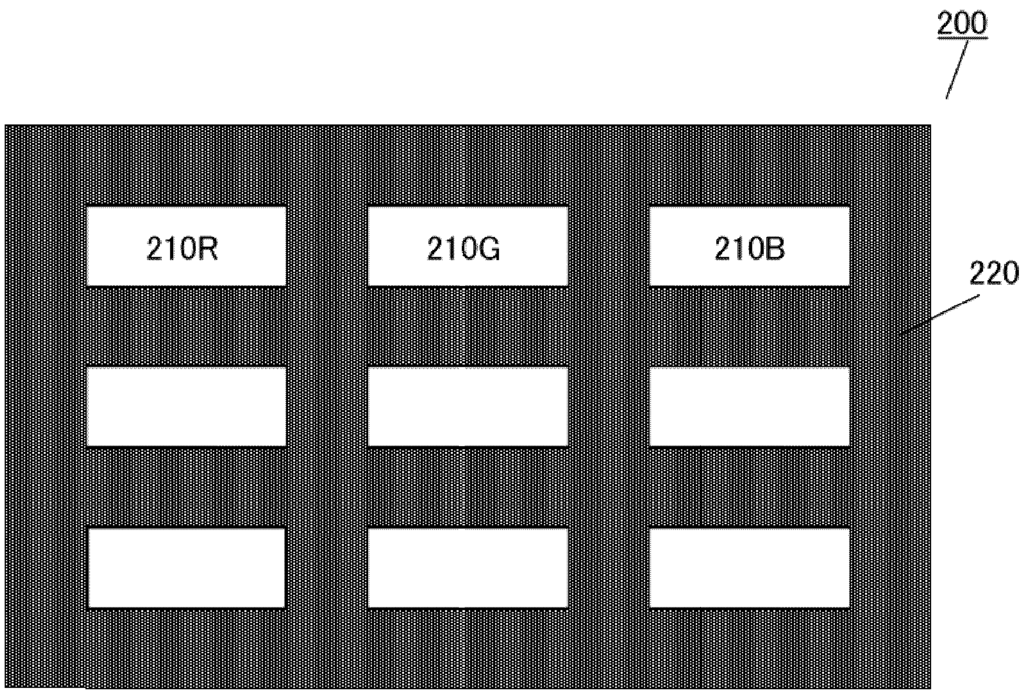
200
210R
210G
210B
220

Fig. 3

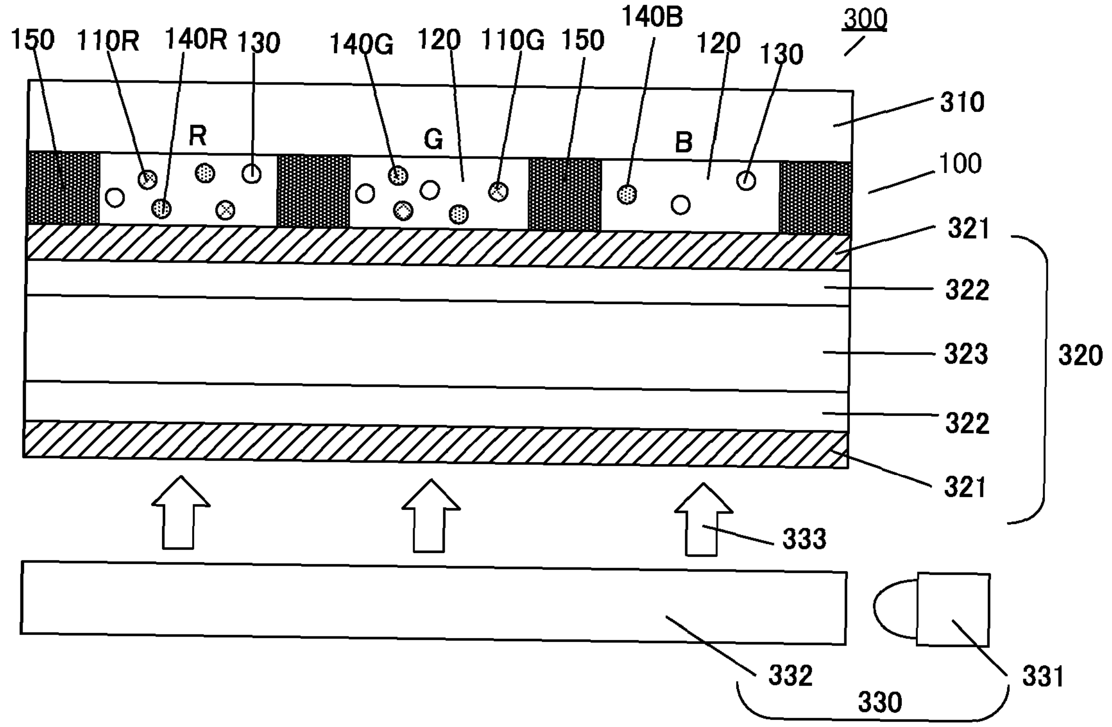
300
150
110R
140R
130
140G
120
110G
150
140B
120
130
R
G
B
310
100
321
322
323
322
321
320
333
332
330
331

Fig. 4

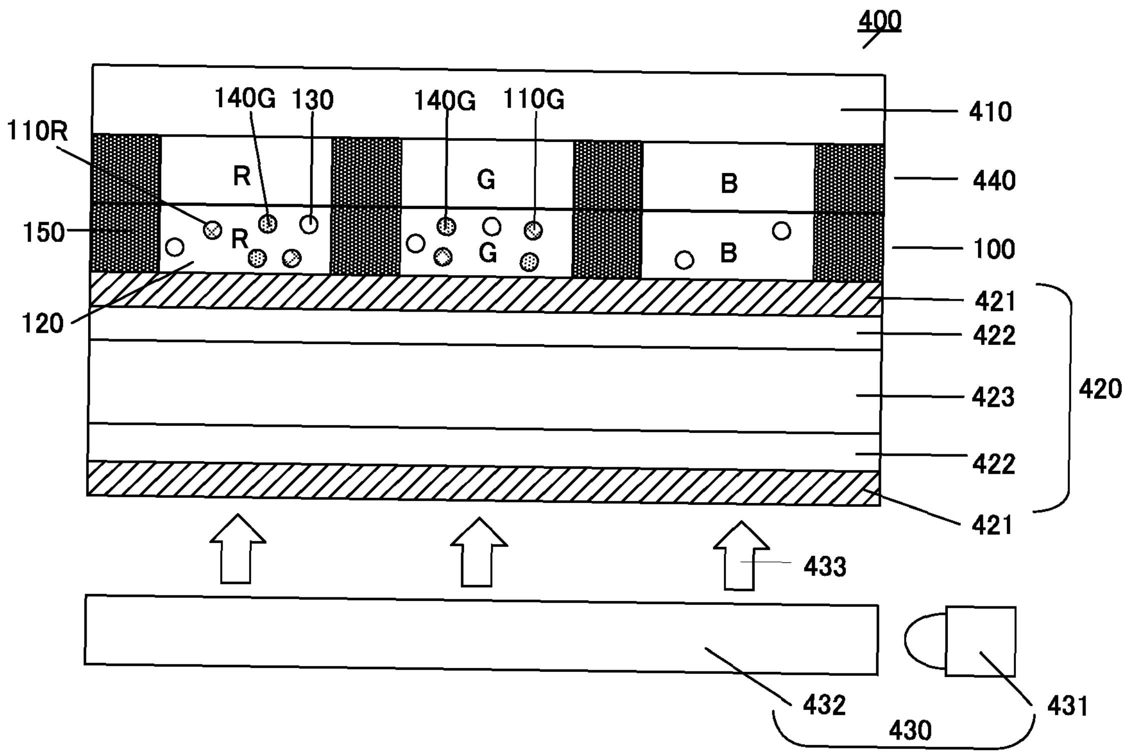
400
110R
140G
130
140G
110G
150
120
R
G
B
R
G
B
410
440
100
421
422
423
422
421
420
433
432
430
431

Fig. 5

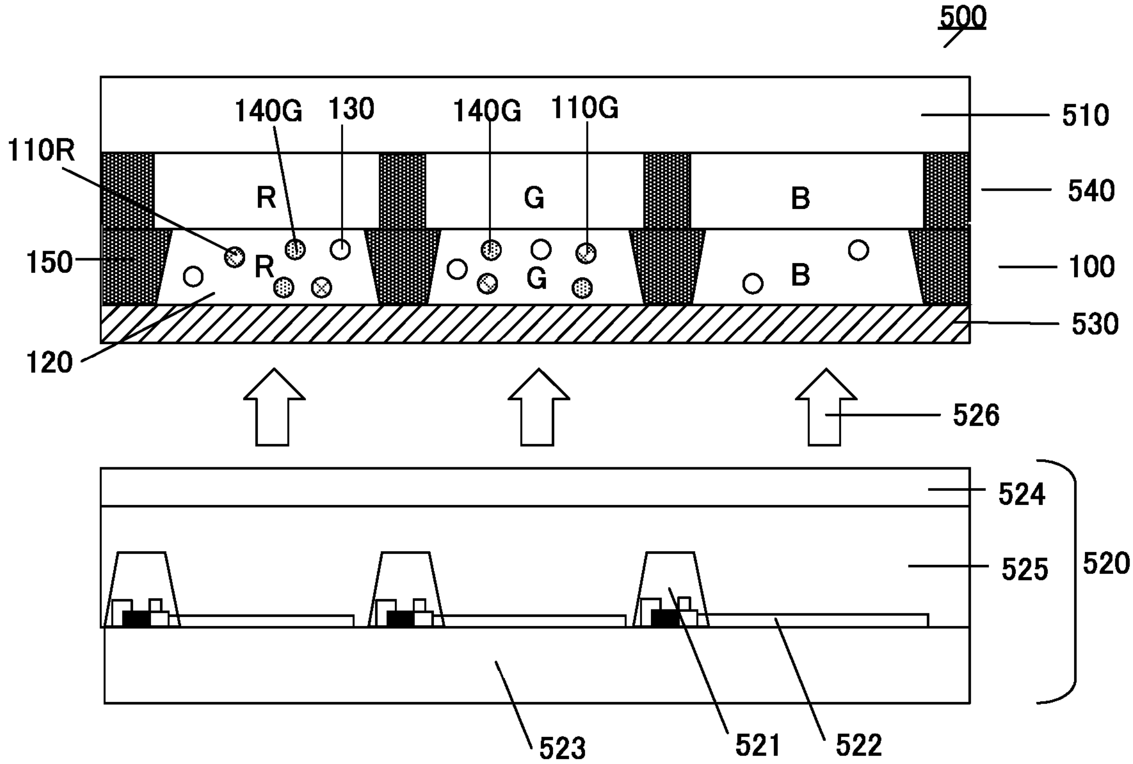
500
140G
130
140G
110G
510
110R
R
G
B
540
150
R
G
B
100
530
120
526
524
525
520
523
521
522

Fig. 6

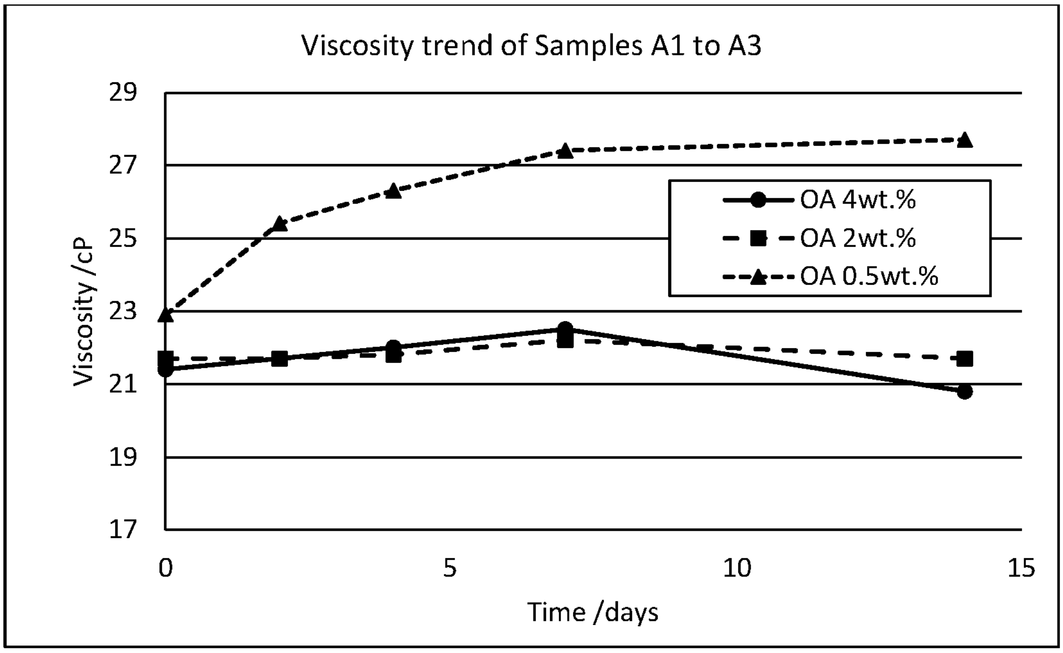
Viscosity trend of Samples A1 to A3
Viscosity /cP
29
27
25
23
21
19
17
0
5
10
15
Time /days
OA 4wt.%
OA 2wt.%
OA 0.5wt.%

Fig. 7

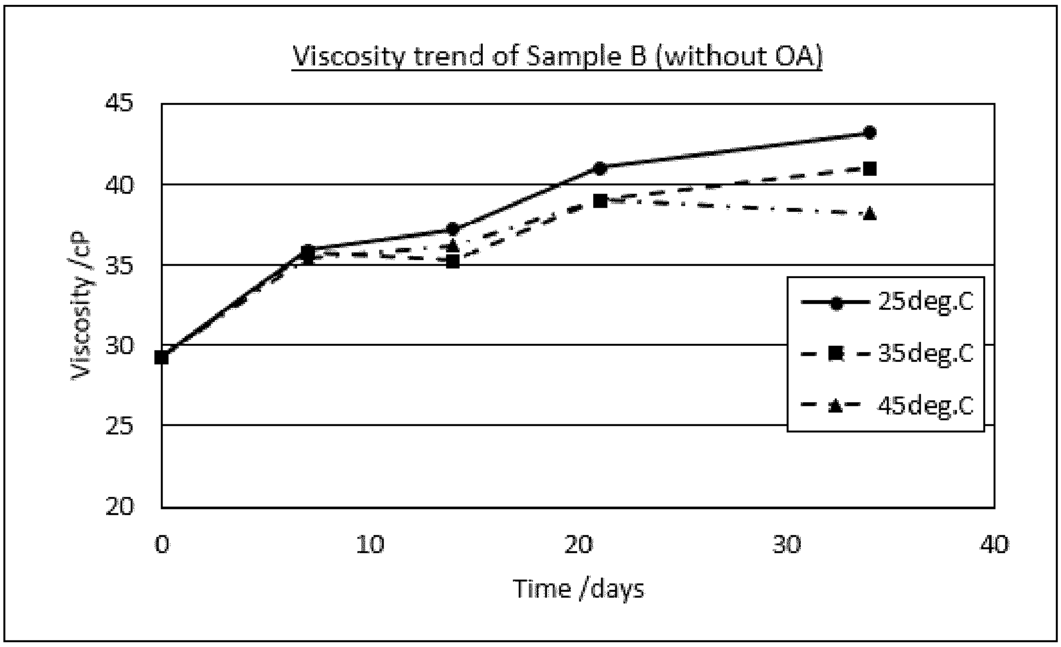
Viscosity trend of Sample B (without OA)
Viscosity /cP
45
40
35
30
25
20
0
10
20
30
40
Time /days
25deg.C
35deg.C
45deg.C

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017054898 A1
- WO 2019002239 A1
- US 2015098212 A1
- US 2018102449 A1
- CN 109535836 A
- US 2020017762 A1
- US 2019218453 A1
- WO 2016134820 A1
- WO 2020208127 A1
- WO 2021116139 A1
- WO 2016134820 A
- US 7588828 B
- US 8679543 B
- WO 2012059931 A
- WO 2021018927 A1
- JP 2004292672 A


### Non-patent literature cited in the description


- **MARC THIRY**. ACSNANO. American Chemical society, 2011, vol. 5, 4965-4973
- **KIMIHIRO SUSUMU**. *J. Am. Chem. Soc.*, 2011, vol. 133, 9480-9496
- *Chem. Mater.*, 2015, vol. 27, 4893-4898